(19) Europäisches Patentamt
European Patent Office
Office européen des brevets

(11) **EP 4 300 116 B1**

(12) **EUROPÄISCHE PATENTSCHRIFT**

(45) Veröffentlichungstag und Bekanntmachung des Hinweises auf die Patenterteilung:
**06.08.2025  Patentblatt 2025/32**

(21) Anmeldenummer: **23182244.6**

(22) Anmeldetag: **29.06.2023**

(51) Internationale Patentklassifikation (IPC):
***G01R 33/34*** *(2006.01)*

(52) Gemeinsame Patentklassifikation (CPC):
**G01R 33/34092; G01R 33/34053**

(54) **NMR-PROBENKOPF MIT REDUZIERTEM ELEKTRISCHEM FELD**

NMR PROBE WITH REDUCED ELECTRIC FIELD

TÊTE D'ÉCHANTILLON RMN À CHAMP ÉLECTRIQUE RÉDUIT

(84) Benannte Vertragsstaaten:
**AL AT BE BG CH CY CZ DK EE ES FI FR GB GR HR HU IE IS IT LI LT LU LV MC ME MK MT NL NO PL PT RO RS SE SI SK SM TR**

(30) Priorität: **01.07.2022  DE 102022206766**

(43) Veröffentlichungstag der Anmeldung:
**03.01.2024  Patentblatt 2024/01**

(73) Patentinhaber: **Bruker Switzerland AG
8117 Fällanden (CH)**

(72) Erfinder: **Freytag, Nicolas
8122 Binz (CH)**

(74) Vertreter: **Kohler Schmid Möbus Patentanwälte
Partnerschaftsgesellschaft mbB
Gropiusplatz 10
70563 Stuttgart (DE)**

(56) Entgegenhaltungen:
WO-A1-2019/226624    US-A- 4 712 068
US-A1- 2016 116 554

• DOTY F D ET AL: "Using a cross-coil to reduce RF heating by an order of magnitude in triple-resonance multinuclear MAS at high fields", JOURNAL OF MAGNETIC RESONANCE, ACADEMIC PRESS, ORLANDO, FL, US, vol. 182, no. 2, 1 October 2006 (2006-10-01), pages 239 - 253, XP024919437, ISSN: 1090-7807, [retrieved on 20061001], DOI: 10.1016/J.JMR.2006.06.031
• PRIVALOV A.F ET AL: "Coil Design for Large-Volume High-B1 Homogeneity for Solid-State NMR Applications", JOURNAL OF MAGNETIC RESONANCE. SERIES A, 1 December 1996 (1996-12-01), pages 157 - 160, XP093066122, DOI: 10.1006/jmra.1996.0229

**Beschreibung**

Hintergrund der Erfindung

Die Erfindung betrifft einen NMR-Probenkopf mit einer Sende-Empfangsspulenanordnung mit mindestens einer Sende-Empfangsspule zur Erzeugung eines HF B1-Magnetfeldes, wobei die Sende-Empfangsspule mindestens einen elektrischen Spulenabschnitt und einen Anschlussbereich umfasst, wobei der elektrische Spulenabschnitt einen Hinwicklungsabschnitt und einen Rückwicklungsabschnitt umfasst, wobei der Hinwicklungsabschnitt Hinwindungen umfasst und ausgehend von dem Anschlussbereich in einem vorgegebenen Windungssinn zu einem axialen Ende der Sende-Empfangsspule führt, und wobei der Rückwicklungsabschnitt Rückwindungen umfasst und ausgehend vom axialen Ende der Sende-Empfangsspule im selben Windungssinn zum Anschlussbereich führt, wobei die Windungen des Rückwicklungsabschnitts eine Ganghöhe mit entgegengesetztem Vorzeichen zu denen des Hinwicklungsabschnitts aufweisen.

Bei der Untersuchung von verlustbehafteten (insbesondere elektrisch leitfähigen) Messproben führen die durch die Spule des NMR-Probenkopfs in der Messprobe erzeugten elektrischen Felder zu Performanceeinbußen, die von Reduktion des Signal-zu-Rausch-Verhältnisses über reduzierte Anregungsbandbreite und Erwärmen bis zur Zerstörung temperaturempfindlicher Messproben reichen können.

Um durch den Probenkopf erzeugte elektrische Felder abzuschirmen, ist es bekannt, die elektrischen Felder in der Probe z.B. mittels einer Faraday-Abschirmung [Pel 2016], [Krahn 2008] oder Spulen, bei denen nur das elektrische Feld einer Windung im Sample sichtbar ist [Stringer 2005], [Dillmann 2007], zu reduzieren.

Eine weitere übliche Maßnahme zur Reduktion der elektrischen Felder in NMR-Probenköpfen ist die Reduktion der Induktivität der Spule für die höchste Messfrequenz bspw. durch eine Kreuzspulen-Konfiguration [Gorkov 2007], [Grant 2009], durch Ersetzen einer Solenoidspule durch induktiv gekoppelte Einzelwindungsresonatoren [US5003265] oder durch Parallelschaltung von Solenoidspulen [US5180982]. Weiterhin sind Ausführungen bekannt, bei denen Solenoidspulen mit parallelgeschalteten Windungen eingesetzt werden [JP4787033]. Durch die Verwendung von niedriginduktiver Spulen und Resonatoren werden jedoch in der Regel nur Verluste bei Messungen auf Protonen-Frequenzen minimiert. Die Verluste bei Messungen auf anderen Frequenzen (X-Kerne) werden in der Regel nicht als Problem wahrgenommen.

Aus [US5180982], [EP1571459] ist bekannt, Spulen zu verwenden, die Windungen mit unterschiedlichem Windungssinn aufweisen, aus [US6751847] sind Spulen bekannt, die mit derselben Windungsrichtung aber invertierter Steigung gewunden sind

Aus [US5180982] und [EP1571459] sind bspw. Spulenanordnungen mit Mittelabgriff bekannt, bei denen sich ausgehend vom Mittelabgriff Spulenteile mit Windungen in entgegengesetzte Richtungen und mit entgegengesetztem Windungssinn aber beide mit positiver Steigung erstrecken, wobei in [US5180982] die beiden Spulenteile mit einer nicht verschwindenden Steigung gewickelt sind, während in [EP1571459] jeweils zwei Windungen in Form von supraleitenden Scheiben senkrecht zur Mittelachse ausgerichtet und mittels Vias (Brückenelementen) verbunden sind. Nachteilig hieran ist, dass die sich über die beiden Hälften der Spule aufgebaute Potentialdifferenz noch ungefähr die Hälfte der Potentialdifferenz eines Solenoids mit doppelter Windungszahl über die volle Länge der Spule ist. Die Reduktion der elektrischen Verluste ist daher begrenzt. Weiterhin sinkt die Induktivität der Sende-/Empfangsspule, was die Effizienz von Mehrkernschaltungen reduziert und zu Performanceeinbussen führt.

[US6751847] schlägt zur Reduzierung der elektrischen Felder eine Spule vor, die auf der Außenseite eines dielektrischen, zylindrischen Trägers Hinwindungen und auf der Innenseite Rückwindungen aufweist. Hin- und Rückwindungen liegen also auf Zylindermantelflächen mit unterschiedlichen Radien. Hin- und Rückwindungen haben denselben Windungssinn aber entgegengesetzte Steigungen. Für eine Messprobe wirkt eine solche Spule wie eine Spule mit halber Windungszahl. Das Leitermaterial der inneren Windungen schirmt die Potentiale der äußeren Windungen ab. Die durch eine solche Spule in einer Messprobe erzeugten elektrischen Felder entsprechen weitestgehend denen, die durch die inneren Windungen der Spule erzeugt werden. Durch die Aufteilung der Windungen auf der Innen- und Außenseite eines dielektrischen Trägers entsteht jedoch eine kapazitive Kopplung zwischen den inneren und äußeren Windungen. Da die Windungen zumindest im Bereich der Zuleitungen große Potentialunterschiede aufweisen, wirkt die Konstruktion stark "kapazitiv", insbesondere dann, wenn der Träger aus einem Material mit hoher Dielektrizitätskonstante wie z.B. Aluminiumoxidkeramik/Saphir oder Zirkonoxidkeramik gefertigt ist. Die Eigenresonanz ist daher verglichen mit einer Spule, die Windungen nur auf einer Trägerseite aufweist, stark reduziert. Um dies auszugleichen muss die Windungszahl und somit die Induktivität der Spule reduziert werden, was wiederum zu Performanceeinbußen beim Abstimmen mehrerer Messfrequenzen auf einer einzelnen Sende-/Empfangsspule führt.

[US4712068] offenbart eine HF-Spulenanordnung, bei der verschiedene Teile ein HF-Feld unterschiedlicher Richtung induzieren, um die Nachteile einer Sattelspule, die üblicherweise als HF-Spule verwendet wird, zu beseitigen. Dazu sind Leiter in ein z.B. zylinderförmiges Netz oder einen ähnlichen Rotationskörper eingeflochten.

[WO2019226624] offenbart eine HF Spule mit einem Hinwicklungsabschnitt, der von einem Anschlussbereich zu einem axialen Ende HF-Spule führt und einen Rückwicklungsabschnitt, der vom axialen Ende zum Anschlussbereich führt, wobei die Windungen des Rückwicklungsabschnitts eine Ganghöhe P mit entgegengesetztem Vorzeichen zu denen des Hinwicklungsabschnitts aufweisen, und die Hin- und Rückwindungen auf einer gemeinsamen Zylindermantelfläche angeordnet sind.

## Aufgabe der Erfindung

Es ist Aufgabe der Erfindung, einen NMR-Probenkopf mit einer Spulengeometrie vorzuschlagen, mit der die im Betrieb in der Probe erzeugten elektrischen Felder reduziert werden und gleichzeitig anderweitige Performanceeinbußen verringert werden können.

## Beschreibung der Erfindung

Diese Aufgabe wird erfindungsgemäß gelöst durch einen NMR-Probenkopf gemäß Patentanspruch 1.

Bei dem erfindungsgemäßen NMR-Probenkopf sind Hin- und Rückwindungen des elektrischen Spulenabschnitts mit Ausnahme von Überkreuzungsbereichen, in denen sich die Hin- und Rückwindungen überkreuzen, auf einer gemeinsamen Zylindermantelfläche um eine Längsachse Z' angeordnet (Crisscross-Geometrie).

Jeder Spulenabschnitt umfasst einen solenoidförmigen Hinwicklungsabschnitt und einen solenoidförmigen Rückwicklungsabschnitt, die zwischen einem axialen Ende der Sende-Empfangsspule und dem Anschlussbereich auf einer gemeinsamen Zylindermantelfläche angeordnet sind, d.h. es befinden sich gegenläufige Wicklungen auf einer gemeinsamen Fläche. Vorzugsweise handelt es sich um eine Kreiszylinderfläche. In diesem Fall befinden sich die Hin- und Rückwindungen dann also auf demselben radialen Abstand um die Längsachse. Es ist jedoch auch denkbar, dass die Hin- und Rückwindungen auf einer gemeinsamen Zylindermantelfläche mit polygonalem, bspw. quadratischem, Querschnitt verlaufen. Unabhängig von der Form des Querschnitts verläuft ein elektrischer Leiter des Hinwicklungsabschnitts ausgehend vom Anschlussbereich mit einem vorgegebenen Windungssinn zu dem axialen Ende der Sende-Empfangsspule und anschliessend von dort aus mit demselben Windungssinn wieder zum Anschlussbereich, wobei die Windungen des Rückwicklungsabschnitts eine Ganghöhe mit entgegengesetztem Vorzeichen zu denen des Hinwicklungsabschnitts, vorzugsweise mit betragsmäßig gleicher Ganghöhe aufweisen. Als Ganghöhe einer Windung wird die Windungshöhe einer vollen Windung verstanden, d.h. die Differenz der Z'-Werte der Leiterbahnmitte für eine volle Rotation um die Längsachse. Der Anschlussbereich dient zum Verbinden des elektrischen Spulenabschnitts mit einem Anpassnetzwerk (Matching Network) und kann Anschlüsse für mehrere elektrische Spulenabschnitte umfassen. Ein Spulenabschnitt verläuft zwischen zwei Anschlüssen des Anschlussbereichs, so dass die angelegte Spannung zwischen dem Anfang der Hinwindungen und dem Ende der Rückwindungen des jeweiligen Spulenabschnitts anliegt.

Um die Hinwindungen und Rückwindungen auf einer gemeinsamen Zylindermantelfläche anzuordnen, müssen sich die Hinwindungen und die Rückwindungen überkreuzen. Die Überkreuzungen werden auf einem möglichst wenig ausgedehnten Abschnitt des Umfangs (Überkreuzungsbereich) ausgeführt, wobei vorzugsweise der elektrische Leiter des Hinwicklungsabschnitts oder des Rückwicklungsabschnitts auf der Zylinderoberfläche verbleibt, wohingegen der jeweils andere elektrische Leiter in Form eines Brückenelements die ersten elektrischen Leiter überquert. Es ist vorteilhaft, wenn der Überkreuzungsbereich weniger als 20%, besser 10% und insbesondere weniger als 5% der Leiterlänge der Hin- oder Rückwindungen umfasst.

Wenn mehrere Spulenabschnitte vorgesehen sind, z.B. wenn der Anschlussbereich zwischen zwei Spulenabschnitten (also nicht an einem axialen Ende der Sende-Empfangsspule) angeordnet ist, können diese als separate Bauteile ausgestaltet sein, die im Anschlussbereich elektrisch miteinander verbunden sind oder als Teile einer leitfähigen Struktur, die auch den Anschlussbereich umfassen kann.

Vorzugsweise ist der NMR-Probenkopfes auf mindestens zwei Frequenzen abgestimmt.

Die Potentiale entlang des Leiters der Spulenabschnitte werden durch das Anpassnetzwerk definiert, mit dem der elektrische Spulenabschnitt über den Anschlussbereich verbunden ist. Im Stand der Technik ist es üblich, das Anpassnetzwerk so auszulegen, dass im Betrieb an den Anschlusspunkten entgegengesetztes und betragsmäßig möglichst gleiches Potential anliegt (balanced network). Wird ein solches Anpassnetzwerk für den erfindungsgemäßen Probenkopf verwendet, liegen an Hinwindungen und Rückwindungen Potentiale mit entgegengesetzten Vorzeichen an. Die Windung am Übergang vom Hinwicklungsabschnitt zum Rückwicklungsabschnitt wird als «Umkehrwindung» bezeichnet. Diese Umkehrwindung umfasst denjenigen Punkt des Leiters, an dem das Potential 0 im Betrieb anliegt. Die Umkehrwindung befindet sich an einem axialen Ende der Sende-Empfangsspule und nimmt eine Sonderstellung ein, da im Bereich der Umkehrwindung ein Vorzeichenwechsel des Potentials und der Ganghöhe des Spulenabschnitts erfolgt. Je nach Anzahl der Windungen des Spulenabschnitts kann die Umkehrwindung dem Hinwicklungs- oder dem Rückwicklungsabschnitt oder teilweise dem Hinwicklungs- und teilweise dem Rückwicklungsabschnitt zugeordnet werden.

Erfindungsgemäß umfasst der Spulenabschnitt eine Umkehrwindung, die einen Punkt mit Potential 0 aufweist, und die Hinwindungen und Rückwindungen eines Spulenabschnitts mit Ausnahme der Umkehrwindung sind abwechselnd angeordnet. Die Windungen des Hinwicklungsabschnitts und des Rückwicklungsabschnitts eines Spulenabschnitts 2a, 2b sind bei dieser Ausführungsform also ineinander verschachtelt, so dass sich zwischen zwei Hinwindungen jeweils eine Rückwindung befindet und sich die Potentiale der benachbarten Windungen weitestgehend kompensieren können.

Die Geometrie der Windungen und des Anschlussbereichs ist so gewählt, dass die Potentiale im Betrieb an vergleichbaren Positionen benachbarter Windungen (Zum Beispiel jeweils am Anfang der Windung oder in der Mitte oder am Ende) betragsmäßig gleich oder ähnlich groß sind. Das Potential wird als ähnlich angesehen, wenn gilt U1/UN = (N/2 - 1) / (N/2) mit U1: Spannung über erster Windung, UN: Spannung über N Windungen.

Vorzugsweise sind die Windungen des Hinwicklungsabschnitts und des Rückwicklungsabschnitts also so ineinander axial verschachtelt, dass sich im Betrieb die maximal mögliche Potentialdifferenz (Summe der Potentialdifferenzen aller benachbarten Windungspaare) zwischen benachbarten Windungen ergibt. Dazu ist insbesondere die erste Windung des Hinwicklungsabschnitts benachbart zu der letzten Windung des Rückwicklungsabschnitts (also die erste und die letzte Windung des elektrischen Spulenabschnitts) angeordnet. Auf diese Weise sind Windungen mit entgegengesetztem Potential benachbart angeordnet.

Bei einer speziellen Ausführungsform des erfindungsgemäßen Probenkopfs ist der Anschlussbereich an einem ersten axialen Ende der Sende-Empfangsspule angeordnet, wobei der Hinwicklungsabschnitt ausgehend von dem Anschlussbereich zu einem zweiten axialen Ende der Sende-Empfangsspule führt, und wobei der Rückwicklungsabschnitt ausgehend vom zweiten axialen Ende der Sende-Empfangsspule zum Anschlussbereich führt. Der elektrische Spulenabschnitt bildet im Prinzip zwei seriell verschaltete axial ineinander verschachtelte solenoidförmige Abschnitte mit gleichem Wicklungssinn, wobei die Hin- und Rückwindungen Ganghöhen mit entgegengesetztem Vorzeichen aufweisen. Der elektrische Spulenabschnitt umfasst also insbesondere ausschließlich Windungen, die um die Längsachse Z' der Sende-Empfangsspule verlaufen.

Eine alternative Ausführungsform sieht vor, dass die Sende-Empfangsspule mindestens zwei elektrische Spulenabschnitte umfasst, und dass der Anschlussbereich zwischen den beiden Spulenabschnitten, vorzugsweise mittig, angeordnet ist. Dabei führen die Hinwindungen des ersten elektrischen Spulenabschnitts ausgehend von dem Anschlussbereich zum ersten axialen Ende der Sende-Empfangsspule und die Rückwindungen des ersten elektrischen Spulenabschnitts ausgehend vom ersten axialen Ende der Sende-Empfangsspule zum Anschlussbereich, und die Hinwindungen des zweiten elektrischen Spulenabschnitts ausgehend von dem Anschlussbereich zum zweiten axialen Ende der Sende-Empfangsspule und die Rückwindungen des zweiten elektrischen Spulenabschnitts ausgehend vom zweiten axialen Ende der Sende-Empfangsspule zum Anschlussbereich.

Diese Ausführungsform umfasst also zwei Spulenabschnitte, die jeweils Hinwindungen und Rückwindungen aufweisen, wobei die Hinwindungen und Rückwindungen jedes Spulenabschnitts auf einer gemeinsamen Zylindermanteloberfläche angeordnet sind. Vorzugsweise sind sämtliche Windungen der beiden Spulenabschnitte auf einer gemeinsamen Zylindermantelfläche angeordnet (mit Ausnahme der Überkreuzungsbereiche). Jeder Spulenabschnitt bildet zwei seriell verschaltete axial ineinander verschachtelte Solenoidspulen, wobei die Spulenabschnitte parallel verschaltet sind. Der Anschlussbereich befindet sich zwischen dem ersten axialen Ende und dem zweiten axialen Ende der Sende-Empfangsspule. Die Spulenabschnitte erstrecken sich in entgegensetzte axiale Richtungen, weisen aber denselben Windungssinn auf.

Vorzugsweise ist am Anschlussbereich (auch bei abwechselnder Anordnung der Hin- und Rückwindungen innerhalb eines Spulenabschnitts) die erste Hinwindung (oder Rückwindung) des ersten Spulenabschnitts (Anschlusswindung des ersten Spulenabschnitts) benachbart zu der ersten Hinwindung (oder Rückwindung) des zweiten Spulenabschnitts (Anschlusswindung des zweiten Spulenabschnitts) angeordnet. Dies vereinfacht das Design und die technische Ausführung des Anschlussbereiches. Insbesondere können die beiden Spulenabschnitte bezüglich des Anschlussbereichs spiegelsymmetrisch zueinander angeordnet sein.

Alternativ kann auch eine über beide Spulenabschnitte durchgehend wechselweise Anordnung von Hin- und Rückwindungen (also einschliesslich der Anschlusswindungen) vorgesehen sein. Dies kann zu einer weiteren Reduktion des elektrischen Feldes in der Messprobe beitragen.

Die Zentrallinie eines Spulenabschnittes ist allgemein definiert als

$$\begin{pmatrix} R(t) * \sin(2\pi t) \\ R(t) * \cos(2\pi t) \\ P(t) * t + T(t) * \cos(2\pi t + \varphi) \end{pmatrix} \text{ mit } t \in \{0...N\},$$

wobei

P: Ganghöhe der Windungen (Strecke, die über eine Windung in Z'-Richtung zurücklegt wird),

T: Neigung der Windungen (Amplitude einer sinusförmigen Modulation der Z'-Position der Leitermittelebene über eine Windung),

φ: Die Orientierung/Richtung der Neigung der Windungen,

R: Radius der Sende-Empfangsspule,

N: Die Summe der Anzahl der Windungen des Hinwicklungsabschnitts NH und des Rückwicklungsabschnitts NR: N = NH + NR, und

wobei t ein Laufparameter ist, der zwischen 0 und der Windungszahl N läuft, mit $t \in \mathbb{R}$ und $0 \leq t \leq N$.

Für S(t) = const. und T(t) = 0 ergibt sich ein normaler Solenoid, ohne Rückwicklungsabschnitt.

Für eine erfindungsgemässe Spule gilt für jeden Spulenabschnitt:

$$\mathrm{sgn}(\int_0^{NH} S(t)\mathrm{d}t) = -\,\mathrm{sgn}(\int_{NH}^{N} S(t)\mathrm{d}t),$$

wobei «sgn» die Vorzeichenfunktion ist.

Bei einer einfachen Ausführungsform der erfindungsgemäßen Sende-Empfangsspule weist sowohl der Hinwicklungsabschnitt als auch der Rückwicklungsabschnitt eine konstante Ganghöhe P auf, wobei die Ganghöhe P des Hin- und Rückwicklungsabschnitts vorzugsweise betragsmäßig gleich groß aber entgegengesetzt sind und die Anzahl der Windungen NH des Hinwicklungsabschnittes gleich der Anzahl Windungen NR des Rückwicklungsabschnittes ist. D. h.: für den Fall konstanter Ganghöhe P und, dass Hinwicklungsabschnitt und Rückwicklungsabschnitt dieselbe Anzahl NH = NR = N/2 an Windungen aufweisen: P(t) = P für t = 0 ... NH (für Hinwicklungsabschnitt) und P(t) = -P für t = NH ... N (für Rückabwicklungsabschnitt). Besonders bevorzugt weist die Sende-Empfangsspule einen solenoidförmigen Hinwicklungsabschnitt und einen solenoidförmigen Rückabwicklungsabschnitt ohne Neigung auf (d.h. T(t) = 0). Eine Ausführungsform ohne Neigung fällt jedoch nicht in den durch die Ansprüche definierten Schutzumfang der Erfindung.

Eine solche Spule kann einfach aus einem Draht oder Bandleiter gefertigt werden, der z.B. um einen Träger gewickelt wird. Ein bandförmiger Leiter hat eine im Verhältnis zur Leiterbahnbreite geringe Dicke (insbesondere mindestens eine Größenordnung kleiner) und weist einen im Wesentlichen rechteckigen Querschnitt auf. Der bandförmige Leiter umfasst vorzugsweise ein Substrat mit einer dünnen Metallisierung, insbesondere einer HTS-Beschichtung.

Vorzugsweise beträgt die Leiterbahndicke W des elektrischen Leiters maximal 500 μm und/oder ist mindestens so groß ist wie die doppelte Eindringtiefe des HF-Magnetfelds B1 in den elektrischen Leiter.

Bei einer besonders bevorzugten Ausführungsform sind die Hin- und Rückwindungen auf einer Kreiszylindermantelfläche angeordnet (d.h. R(t) = const). Dies ist besonders einfach zu fertigen, da ein kreiszylinderförmiger Träger verwendet werden kann.

Besonders bevorzugt sind die elektrischen Spulenabschnitte als bandförmige Spulenabschnitte mit einer Leiterbahnbreite W ausgeführt Die Leiterbahnbreite ist die Breite der Leiterbahn senkrecht zur Leitermitte. Ein bandförmiger Spulenabschnitt weist eine Leiterbahnbreite auf, die größer ist als die Dicke des Spulenabschnitts. Dabei kann die Bandbreite über den kompletten Leiter konstant sein (W = konst.) oder variieren (W = W(t)). Im Falle einer über den Verlauf t der Länge des elektrischen Leiters variierenden Leiterbreite W(t), kann die Leiterbreite auch innerhalb einer Windung variieren. Bandförmige Spulenabschnitte können beispielsweise aus einem rohrförmigen Rohling durch Herausätzen, Herausfräsen oder Herausschneiden von nicht benötigten Bereichen hergestellt werden. Weiterhin können zylinderförmige Leiter um einen Träger gewickelt und auf diesem flach gepresst werden oder Bandförmige Leiter werden auf einen Träger gewickelt und auf die Oberfläche gepresst. Ohne Verpressen führt die Torsion beim Winden dazu, dass die Leiter nicht flächig auf dem Träger aufliegen. Es können auch Rundleiter auf einem Träger gewickelt werden und diese im Anschluss durch Verpressen zu Bandleitern umgeformt werden.

Bei einer speziellen Ausführungsform variiert innerhalb des Hinwicklungsabschnitts und/oder des Rückwicklungsabschnitts die Leiterbahnbreite des elektrischen Leiters und/oder die Spaltbreite D zwischen benachbarten Windungen des Hinwicklungsabschnitts und/oder des Rückwicklungsabschnitts entlang der Länge t des elektrischen Leiters (W = W(t), mit t = 0...N).

Insbesondere kann die Leiterbahnbreite W des elektrischen Spulenabschnitts und/oder die Spaltbreite D zwischen benachbarten Windungen der Sende-Empfangsspule innerhalb jeder Windung variieren. Vorzugsweise variiert die Leiterbahnbreite innerhalb jeder Windung zwischen einem minimalen Wert und einem maximalen Wert, derart, dass die Leiterbahnbreite innerhalb jeder Windung mindestens zweimal abnimmt und zweimal zunimmt, vorzugsweise periodisch. Jede Windung des Spulenabschnitts umfasst also zwei Bereiche mit minimaler Leiterbahnbreite und zwei Bereiche mit maximaler Leiterbahnbreite. Eine solche Ausführungsform erlaubt eine höhere Effizienz einer Sende-/Empfangsspule mit T(t) ≠ 0 als eine Spule mit konstanter Leiterbahnbreite. Weiterhin erlaubt dies eine höhere Transparenz für Magnetfelder einer zweiten Spule in einer Kreuzspulenanordnung, ohne die Güte zu stark negativ zu beeinflussen. Wenn die Bereiche des elektrischen Spulenabschnitts mit minimalem Wert für die Leiterbahnbreite bezüglich einer Rotation um die Längsachse um 180° versetzt angeordnet sind, liegen Bereiche mit Minimalbreite auf sich gegenüberliegenden Zylindermantelsegmenten der Zylindermantelfläche, was dazu führt, dass Freiräume mit maximaler Spaltbreite auf sich gegenüberliegenden Zylindermantelsegmenten liegen. Dadurch entstehen vermehrt transparente Bereiche, die genutzt werden können, um ein zweites HF-Magnetfeld, das durch eine zweite Spule des MR-Probenkopfs erzeugt wird, dem ersten HF-Magnetfeld zu überlagern. Das Probenvolumen ist dann für beide HF-Magnetfelder «sichtbar». Gleichzeitig kann die Sende-Empfangsspule in den übrigen Bereichen eine Leiterbahnbreite aufweisen, welche die Güte der Spule optimiert. Auf diese Weise kann der Probenkopf effizient auf mehrere Frequenzen abgestimmt werden.

Bei einer weiteren speziellen Ausführungsform variiert die Steigung S, insbesondere die Ganghöhe P der Windungen entlang der Länge t des elektrischen Spulenabschnitts.

Eine Änderung der Steigung S= S(t) kann realisiert werden durch eine Änderung der Ganghöhe P (Steigung einer Windung), aber auch bereits durch eine Änderung der lokalen Steigung S innerhalb einer Windung bei konstantem P.

Die Steigung S ist also abhängig von der Position entlang des Leiters (S = S(t)).

Die Ganghöhe P ist definiert als das Integral der Steigung über eine Windung P $= \int_{tn}^{tn+1} S(t)\mathrm{d}t$ , also diejenige Strecke, um die sich der elektrische Leiter nach einer vollen Umdrehung in Richtung Längsachse windet, d.h. P = z'(tn) - z'(tn+1). Dabei ist tn der Anfang der n-ten Windung. Da t ein Einheitenloser Laufparameter ist, ist die Ganghöhe P bei konstanter Steigung S gleich der Steigung S, also wenn S(t)=S für den Bereich t = t0 ... t0+1.

Die mehreren Windungen können auch als Einzelwindungen, die induktiv oder kapazitiv gekoppelt sind, ausgeführt sein. Die Ganghöhe P beschreibt dann den Abstand zweier benachbarter Einzelwindungen. Durch eine variable Steigung S kann die Homogenität entlang der z-Achse (on-axis) verbessert werden. Auch bei einer Spule mit konstanter Ganghöhe P kann die lokale Steigung S innerhalb einer Windung variieren und dabei sogar das Vorzeichen kehren. Die Ganghöhe P einer Windung soll als positiv bezeichnet werden, wenn die Z'-Koordinate der Mittellinien für t0+1 größer ist als die Z'-Koordinate bei t0. Dies gilt selbst dann, wenn die Z'-Koordinate im Intervall zwischen t0 und t0+1 kleinere Werte annimmt als bei t0.

Für endliche Solenoid-Spulen fällt die Amplitude des B1-Magnetfelds an den axialen Enden ab. Durch eine Verringerung der Ganghöhe P an den axialen Enden kann erreicht werden, dass die Windungen dichter beieinanderliegen. Somit kann die aufgrund der Endlichkeit der Spule fehlende Stromdichte kompensiert werden. Eine Verbesserung der Homogenität entlang der Längsachse Z' für kurze Sende-Empfangsspulen, die fern der Eigenresonanzen betrieben werden, ergibt sich daher insbesondere dann, wenn die Ganghöhe P an den axialen Enden der Sende-Empfangsspule kleiner ist als im axialen Zentrum.

Betreibt man eine "kurze" Sende-Empfangsspule mit Mittelabgriff an/in der Nähe der Eigenresonanz, ist es hingegen vorteilhaft, die Ganghöhe P in der Mitte zu reduzieren, da die ungefähr sinusförmige Stromverteilung entlang der Länge des Spulenabschnitts das erzeugte Feld im Zentrum reduziert, was man durch "Verdichten" der Windungen innerhalb der Spulenabschnitte kompensieren kann. Die höchste Stromdichte tritt bei solchen Spulen in der/den Umkehrwindungen auf, was i.d.R. die fehlende Stromdichte einer kurzen Solenoidspule weitestgehend kompensiert.

Zur Verbesserung der Homogenität in radialer Richtung (off-axis) sieht die Erfindung vor, dass die Windungen der Sende-Empfangsspule entlang des Leiters eine variable Neigung gegenüber der Längsachse Z' aufweisen, d.h. T = T(t).

Die Neigung T ist definiert als Amplitude einer sinusförmigen Modulation der Z'-Position der Leitermittelebene über eine Windung. Eine Spule mit Neigung $T \neq 0$ kann prinzipiell auch durch eine variable Steigung S'(t)= S(t) + $T(t)\cos(2\pi t + \varphi)$ beschrieben werden. Wenn S'(t) als Fourierreihe geschrieben wird, dann beschreibt T den (k = 1)-periodischen Anteil der Steigung S. Für jede Windung kann die Steigung S geschrieben werden als:

$$S'(t) = S_0 + \sum_{k=1}^{\infty}\left(S_{k,a}\cos(k\,2\pi\,t) + S_{k,b}\sin(k\,2\pi\,t)\right),$$

wobei

$$S(t) = S'(t) - \left(S_{1,a}\cos(2\pi\,t) + S_{1,b}\sin(2\pi\,t)\right).$$

$(S_{1,a}\cos(2\pi t) + S_{1,b}\sin(2\pi t))$ kann als $T(t)\cos(2\pi t + \varphi)$ geschrieben werden, wobei T die Neigung und $\varphi$ die Richtung der Neigung ist (i.d.R. ist $\varphi = 0$ oder $\varphi = 90°$).

Die Neigung T kann über den Verlauf t der Länge des elektrischen Leiters variieren (T = T(t)). In diesem Fall ist die Neigung abschnittsweise konstant, insbesondere für mindestens eine Halbwindung (halbe Windung). Die Neigung ändert sich dann also von Halbwindung zu Halbwindung, d.h. dass jede Halbwindung mit einer Neigung T gegenüber der Längsachse Z' geneigt ist, wobei für zumindest einen Teil der Halbwindungen (halbe Windung) $T \neq 0$ gilt. Die Neigung T der Windungen hat Einfluss auf die B1-Amplitude und die radiale Homogenität. Bei einer Spule mit Neigung $T \neq 0$ unter-

scheidet sich die Steigung S innerhalb der ersten Windungshälfte von der in der zweiten Windungshälfte. In der Regel ist die Neigungsrichtung $\varphi = 0$ (Neigung um die Y' Achse) oder n/2 (Neigung um die X' Achse) und der Radius R(t) = R.

Bei Spulen, bei denen die Steigung S eine beliebige Funktion S(t) ist, macht die Definition der Neigung nur bedingt Sinn, da der Effekt von T(t) auch über S(t) ausgedrückt werden kann. T(t) reflektiert einen periodisch variierenden Anteil der variablen Steigung S, der einem Neigen der (elliptischen) Windungen gegenüber der Achse Z' entspricht.

Wenn die Längsachse der Sende-Empfangsspule nicht kollinear mit dem für die NMR Messung verwendeten statischen Magnetfeld B0 angeordnet ist, wie z.B. bei MAS-Messungen (magic angle spinning), kann durch Neigung der Sende-Empfangsspule auch die Amplitude des durch die Sende-Empfangsspule erzeugten HF-Magnetfelds B1 und damit die Effizienz der Sende-Empfangsspule erhöht werden, insbesondere, wenn diese als Solenoidspule ausgebildet ist oder solenoidförmige Abschnitte umfasst: Bei MAS NMR Messungen wird eine Messprobe um die Längsachse Z' rotiert, die vorzugsweise um den magischen Winkel $\theta$ ($\theta = 54,74°$) gegenüber einer Z-Achse, die durch das statische Magnetfeld B0 definiert wird und in der sich im Betrieb (also wenn der NMR-Probenkopf in der NMR-Apparatur montiert ist) i.d.R. die längliche Ausdehnung des NMR-Probenkopfs erstreckt, verkippt ist. Durch die Neigung der Windungen der Sende-Empfangsspule können Feldkomponenten des HF-Magnetfelds B1 parallel zum statischen Magnetfeld B0 minimiert, respektive die Feldkomponenten des HF-Magnetfeld B1 orthogonal zum statischen Magnetfeld B0 maximiert werden. Durch das Neigen der Windungen steht jedoch, im Gegensatz zu konventionellen (nicht geneigten) Solenoidspulen, das HF-Magnetfeld B1 im Messvolumen nicht mehr parallel zu Z', so dass die Leiter der Spule "dem von ihr erzeugten Feld im Weg stehen". Eine Reduktion der Leiterbahnbreite der geneigten Solenoidspule in diesen Bereichen erhöht die Sende-Effizienz und das mögliche Signal-zu-Rauschverhältnis einer erfindungsgemäßen geneigten Solenoidspule.

Eine besonders bevorzugte Ausführungsform sieht vor, dass sich mindestens zwei der Größen Neigung T, Steigung S, Leiterbahnbreite W über den Verlauf t der Länge des elektrischen Leiters der Sende-Empfangsspule ändern, insbesondere die Steigung S und einer der Größen Neigung T und Leiterbahnbreite W. Hierdurch kann eine auf das Signale-zu-Rausch-Verhältnis (SNR) optimierte Sende-Empfangsspule realisiert werden. Erfindungsgemäß ist dabei jedoch stets eine variable Neigung entlang des Spulenabschnitts vorhanden.

Eine weitere Ausführungsform sieht vor, dass mindestens eine Windung fast über die volle Umdrehung, insbesondere außerhalb des Überkreuzungsbereichs, eine Steigung S = 0 aufweist (eine so genannte "zero-pitch" Spule). Eine solche Windung bildet dann einen nicht geschlossenen Ring, d.h. S(t) = 0 gilt für t = t0 ... t0+1- $\varepsilon$ oder t = t0+ $\varepsilon$/2 ... t0+1-$\varepsilon$/2, mit $\varepsilon$ >0, wobei $\varepsilon$ >0 einen Kurzschluss verhindert; t = t0 ist der Anfang der Windung. Bei einer nicht geneigten Sende-Empfangsspule (d.h. bei T = 0) sind die Windungen über den kompletten Bereich, in dem sie Steigung S = 0 aufweisen, senkrecht zur Längsachse ausgerichtet. Eine solche Sende-Empfangsspule kann als Kombination von nicht geschlossenen «Ringen» ohne Steigung und Abschnitten des elektrischen Spulenabschnitts mit Steigung S > 0 konzipiert werden. Dadurch kann das Verhältnis Leiterbahnbreite zu Spaltbreite über die Sende-Empfangsspule hinweg konstant gehalten werden. Dadurch kann besonders einfach die Güte der Sende-Empfangsspule maximiert werden und/oder die elektrischen Felder minimiert werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern die dadurch erhaltene Merkmalskombination in den durch die Ansprüche definierten Schutzumfang der Erfindung fällt. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Offenbarung und Zeichnung

Fig. 1a     zeigt eine perspektivische Darstellung einer Ausführungsform einer Sende-Empfangsspule für einen Probenkopf, bei der der Anschlussbereich mittig zwischen den beiden axialen Enden der Sende-Empfangsspule angeordnet ist.

Fig. 1b     zeigt eine Abwicklungsdarstellung der Sende-Empfangsspule aus Fig. 1a.

Fig. 2a     zeigt eine perspektivische Darstellung einer weiteren Ausführungsform einer Sende-Empfangsspule für einen Probenkopf, bei der der Anschlussbereich an einem axialen Ende der Sende-Empfangsspule angeordnet ist.

Fig. 2b     zeigt eine Abwicklungsdarstellung der Sende-Empfangsspule aus Fig. 2a.

Fig. 3     zeigt eine Simulation des Verlaufs der Isolinien des elektrischen Feldes bei der Sende-Empfangsspule gemäß Fig. 2.

Fig. 4a     zeigt einen Ausschnitt eines solenoidförmigen Spulenabschnitts zur Veranschaulichung der Spulenparame-ter mit T $\neq$ 0.

Fig. 4b     zeigt einen Ausschnitt eines solenoidförmigen Spulenabschnitts zur Veranschaulichung der Spulenparameter mit T = 0.

Fig. 5     zeigt eine Abwicklungsdarstellung einer Ausführungsform einer Sende-Empfangsspule für einen Probenkopf, bei der Leiterbahnbreite und Spaltbreite zwischen benachbarten Windungen der Sende-Empfangsspule entlang der Länge des elektrischen Spulenabschnitts variiert.

Fig. 6 zeigt eine Abwicklungsdarstellung einer Ausführungsform einer Sende-Empfangsspule für einen Probenkopf, bei der die Leiterbahnbreite und die Spaltbreite innerhalb jeder Windung des Leiters variiert.

Fig. 7 zeigt eine Abwicklungsdarstellung einer Ausführungsform einer Sende-Empfangsspule für einen erfindungsgemäßen Probenkopf, mit einer innerhalb jeder Windung variablen Steigung S und einer konstanten Ganghöhe P.

Fig. 8 zeigt eine Abwicklungsdarstellung einer Ausführungsform einer Sende-Empfangsspule für einen erfindungsgemäßen Probenkopf, bei der die Windungen der Sende-Empfangsspule entlang des Spulenabschnitts eine variable Ganghöhe P und variable Leiterbahnbreite entlang der gesamten Länge des elektrischen Spulenabschnitts aufweisen.

Fig. 9 zeigt eine Abwicklungsdarstellung einer Ausführungsform einer Sende-Empfangsspule für einen erfindungsgemäßen Probenkopf, bei der die Neigung der Windungen gegenüber der Längsachse Z' ungleich Null ist.

Fig. 10 zeigt eine schematische Darstellung eines erfindungsgemäßen NMR-Probenkopfs.

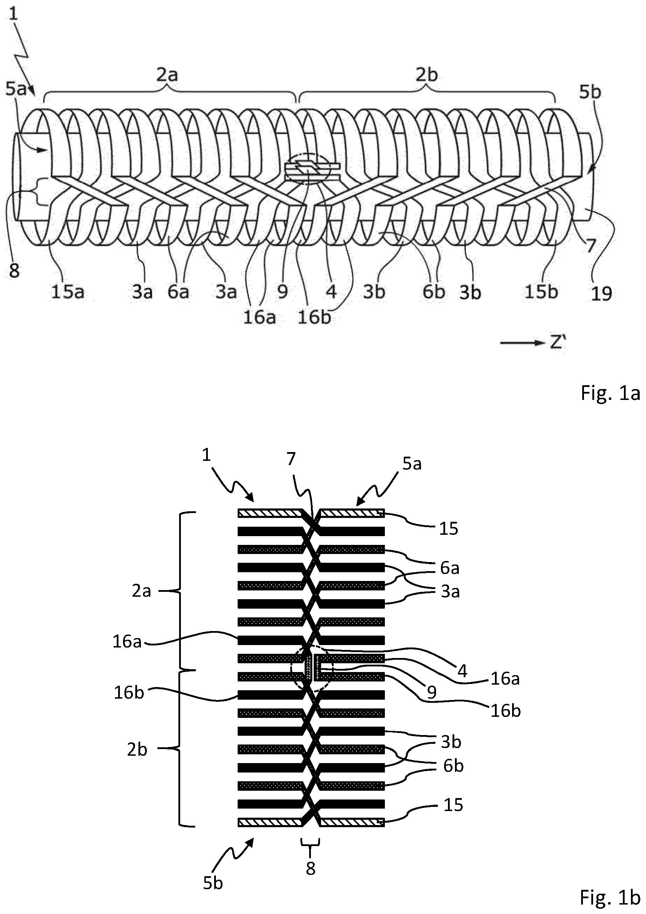

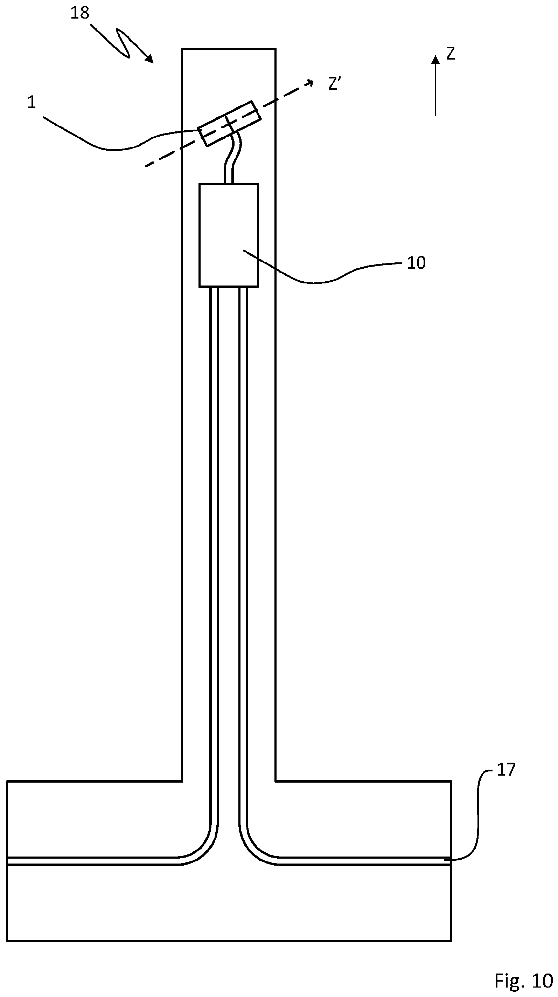

Die **Fig. 1a, 1b** zeigen in einer perspektivischen Darstellung und in einer Abwicklungsdarstellung eine besonders bevorzugte Ausführungsform einer Sende-Empfangsspule **1** für einen NMR-Probenkopf 18 (s. Fig. 10). In der Sende-Empfangsspule 1 ist eine zu untersuchende Messprobe **19** angeordnet. Die Sende-Empfangsspule 1 weist zwei Spulenabschnitte **2a, 2b** mit Hinwindungen **3a, 3b,** die von einem Anschlussbereich **4** zu je einem axialen Ende **5a, 5b** der Sende-Empfangsspule 1 verlaufen, und Rückwindungen **6a, 6b,** die von dem jeweiligen axialen Ende 5a, 5b zurück zum Anschlussbereich 4 verlaufen, auf. Die Windungen, die am Anschlussbereich 4 enden/beginnen, werden als Anschlusswindungen **16a, 16b** bezeichnet. Die Hinwindungen 3a des ersten Spulenabschnitts 2a und die Hinwindungen 3b des zweiten Spulenabschnitts 2b weisen denselben Windungssinn auf. Die Rückwindungen 6a, 6b weisen einen bezüglich der Hinwindungen 2a, 2b jeweils entgegengesetzte Ganghöhen P aber den jeweils gleichen Windungssinn auf. Die Hinwindungen 3a, 3b und die Rückwindungen 6a, 6b werden über eine Umkehrwindung **15a, 15b** verbunden, die an dem, dem Anschlussbereich 9 gegenüberliegenden Ende 5a, 5b des jeweiligen Spulenabschnitts 2a, 2b angeordnet ist, und eine Umkehrung des Vorzeichens der Ganghöhe P der Windungen bewirkt. Dabei verläuft der zurückgeführte Leiter (Rückwindungen) auf derselben Fläche (hier: Kreiszylindermantelfläche) wie die hinführenden Leiter (Hinwindungen). Die Rückwindungen 6a, 6b sind in den Zwischenräumen zwischen zwei Hinwindungen 3a, 3b angeordnet. Die dafür notwendigen Überkreuzungen **7** werden auf einem möglichst wenig ausgedehnten Abschnitt des Umfangs (Überkreuzungsbereich **8**) ausgeführt. Die Überkreuzungen 7 der Hin- und Rückwindungen 3a, 3b, 6a, 6b sind mittels Brückenelementen ausgeführt. Bei den Brückenelementen handelt es sich um Verbindungselemente, die aus der gemeinsamen Umfangsfläche heraus- und wieder hineinführen. Die beiden Spulenabschnitte 2a, 2b sind bezüglich des Anschlussbereichs 4 spiegelsymmetrisch zueinander, so dass, obwohl innerhalb jedes Leiterabschnitts die Hin- und Rückwindungen abwechselnde angeordnet sind, am Anschlussbereich 4 die erste Hinwindung (oder Rückwindung) des ersten Spulenabschnitts 2a (Anschlusswindung 16a des ersten Spulenabschnitts 2a) benachbart zu der ersten Hinwindung (oder Rückwindung) des zweiten Spulenabschnitts 2b (Anschlusswindung 16b des zweiten Spulenabschnitts 2b) angeordnet ist.

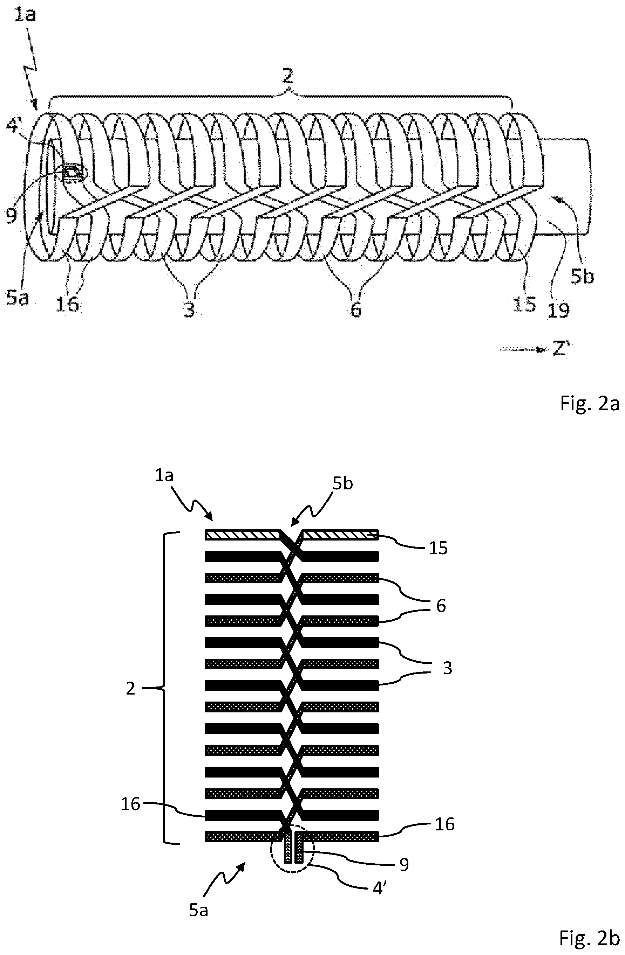

Die **Fig. 2a, 2b** zeigen in einer perspektivischen Darstellung und in einer Abwicklungsdarstellung eine alternative Ausführungsform einer Sende-Empfangsspule **1a** mit nur einem Spulenabschnitt **2** mit Hinwindungen **3** und Rückwindungen **6.** Hier wird der elektrische Leiter ausgehend von dem axialen Ende 5a der Sende-Empfangsspule 1a in einem vorgegebenen Windungssinn zum anderen axialen Ende 5b der Spule geführt und anschliessend von dort aus mit entgegengesetzter Ganghöhe P aber demselben Windungssinn wieder zum ersten axialen Ende 5a zurück. Ein Anschlussbereich **4'** befindet sich bei dieser Ausführungsform im Gegensatz zu der in Fig. 1 gezeigten Ausführungsform also am ersten axialen Ende 5a. Wie auch bei der in Fig. 1 gezeigten Ausführungsform befinden sich bei der in Fig. 2 gezeigten Ausführungsform die Rückwindungen 6 auf derselben Fläche wie die Hinwindungen 3, wobei die Rückwindungen 6 in den Zwischenräumen zwischen zwei Hinwindungen 3 angeordnet sind. Die Hinwindungen 3 und die Rückwindungen 6 werden auch hier über eine Umkehrwindung **15** verbunden, die an dem Anschlussbereich 4' gegenüberliegenden Ende 5b des Spulenabschnitts 2 angeordnet ist und eine Umkehrung des Vorzeichens der Ganghöhe P der Windungen bewirkt. Bei der ersten Hinwindung und der letzten Rückwindung (Windungen am Anschlussbereich 4') handelt es sich um die Anschlusswindung **16.**

Für alle Ausführungsformen der offenbarten Spulengeometrie gilt, dass ein

Spulenabschnitt 2, 2a, 2b im Sinne der Offenbarung sowohl Hin- als auch Rückwindungen aufweist, wobei sich die Rückwindungen 6a, 6b auf derselben Fläche wie die Hinwindungen 3a, 3b befinden und entgegengesetzte Ganghöhen P aufweisen. Bei den in den Figuren gezeigten speziellen Ausführungsformen ist innerhalb jedes Spulenabschnitts 2a, 2b je eine Rückwindung 6a, 6b in einem Zwischenraum zwischen zwei Hinwindungen 3a, 3b angeordnet.

Im Falle von zwei Spulenabschnitten 2a, 2b (Fig. 1, Fig. 5-9) ist der Aufbau der gezeigten Ausführungsformen der Sende-Empfangsspule spiegelsymmetrisch angeordnet, so dass im Anschlussbereich 4, Rückwindungen- oder Hinwindungen der beiden Spulenabschnitte benachbart angeordnet sind.

Bei allen Ausführungsformen befinden sich im Anschlussbereich 4, 4' Anschlüsse **9,** über die Anschlusswindungen 16a, 16b der beiden Leiterabschnitte 3a, 3b an ein Anpassnetzwerk **10** (s. Fig. 10) angeschlossen werden kann, um die Sende-Empfangsspule 1, 1a beim Senden von RF-Pulsen mit Energie zu versorgen, respektive das nach der Anregung der Messprobe 19 in der Sende-Empfangsspule induzierte Signal zu detektieren. Der Anschlussbereich kann sich, insbesondere für Ausführungsformen mit mehreren Spulenabschnitten an einem Ende, in einem oder mehreren mittleren Bereichen oder an beiden Enden, sowie Kombinationen aus mittleren Bereichen und Enden befinden.

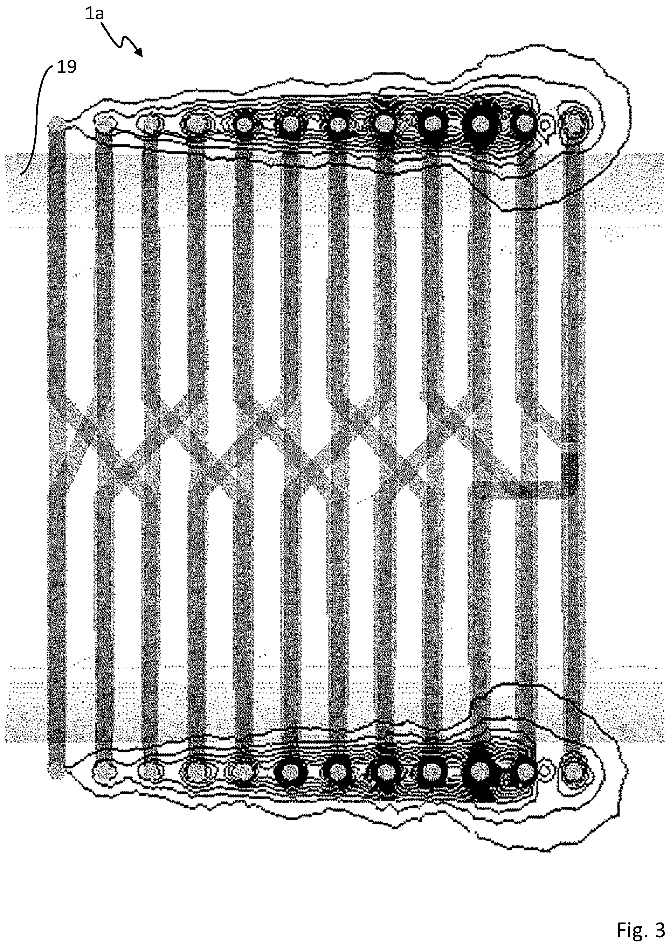

Im Stand der Technik ist es üblich, das Anpassnetzwerk 10 so auszulegen, dass im Betrieb an den Anschlüssen 9 ein entgegengesetztes und betragsmäßig möglichst gleiches Potential anliegt. Dies führt i.d.R. dazu, dass in der Messprobe ein mit einer Ausführungsform einer Sende-Empfangsspule minimal mögliches elektrisches Feld auftritt. Bei den offenbarten Sende-Empfangsspulen-Geometrien werden Windungen mit gegensätzlichen Potentialen auf demselben radialen Abstand zur Längsachse der Sende-Empfangsspule angeordnet und zwar derart, dass sich die Potentiale benachbarter Windungen 3-6; 3a-6a; 3b-6b kompensieren, d.h. betragsmäßig möglichst ähnlich sind, aber entgegengesetzte Vorzeichen aufweisen. Eine Simulation des Verlaufs der Isolinien des elektrischen Feldes um die elektrischen Leiter einer Sende-Empfangsspule 1a analog zur Spule aus der Fig. 2 ist in **Fig. 3** gezeigt. Dadurch, dass die Windungen mit den größten Potentialunterschieden benachbart angeordnet sind, konzentriert sich das elektrische Feld auf die Zwischenräume und klingt mit zunehmendem Abstand zur Sende-Empfangsspule 1a sehr schnell ab. Daher verlaufen die elektrischen Felder nur wenig ins Innere der Sende-Empfangsspule 1a, wo sich das Field of View befindet, in dem die Messprobe 19 angeordnet wird. Wird ein NMR-Messkopf mit einer leitfähigen Messprobe oder einer Messprobe mit hohen dielektrischen Verlusten beladen, führen elektrische Felder während des Sendens von RF-Pulsen zu Dissipation in der Messprobe, die die Messprobe erwärmen kann. Im Empfangsfall wird durch elektrische Felder Rauschen aus der Messprobe aufgenommen. Dies ist besonders dann von großem Nachteil, wenn die Sende-/Empfangsspule kryogen gekühlt wird und eine deutlich tiefere Temperatur als die Messprobe aufweist. Minimale elektrische Felder in der Messprobe 19, wie sie mit den offenbarten

Geometrien ermöglicht werden, garantieren für kryogen gekühlte NMR-Messköpfe ein gutes Signal-Rausch-Verhältnis auch im Betrieb mit verlustbehafteten Messproben 19.

Eine weitere Optimierung des NMR-Probenkopfs kann durch Variation von Spulenparametern der Sende-Empfangsspule erfolgen:

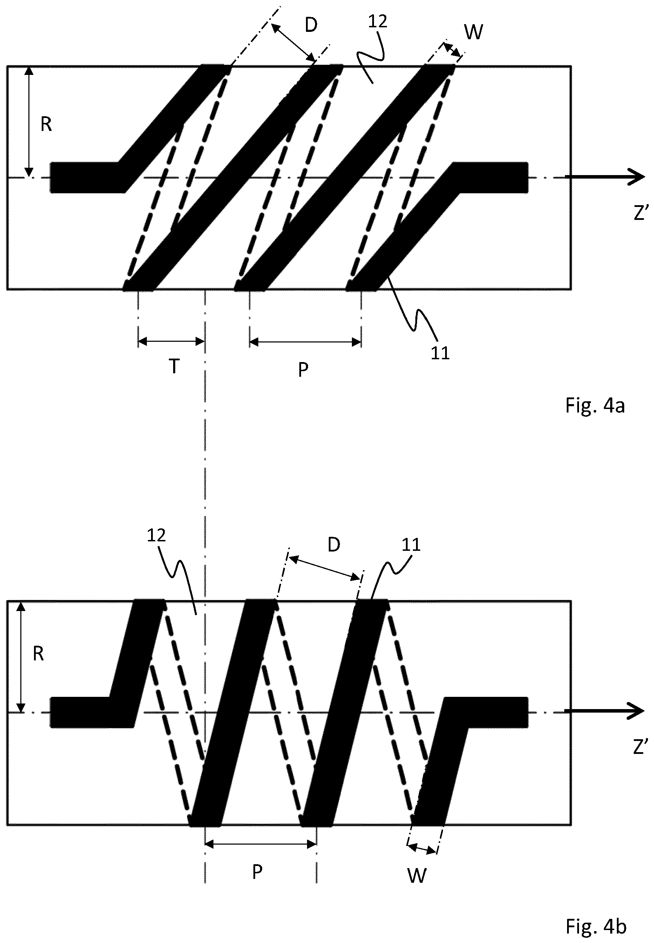

In **Fig. 4a** und **Fig. 4b** ist jeweils ein Ausschnitt einer solenoidförmigen Spule mit einem bandförmigen Leiter (Leiterbahn **11**) schematisch dargestellt, anhand derer zunächst die Spulenparameter veranschaulicht werden. Die solenoidförmige Spule in Fig. 4a und Fig. 4b ist entlang der Längsachse Z' (Spulenachse) angeordnet, wobei die Längsachse Z' senkrecht auf einer X'Y'-Ebene steht. Die solenoidförmige Spule wird durch eine Leiterbahnbreite **W** der Leiterbahn 11, einer Spaltbreite **D** eines Zwischenraums **12,** einer Ganghöhe **P** der Windungen, einer Neigung **T** der Windungen und einem Radius **R** der Windungen parametrisiert. In der hier gezeigten Ausführungsform sind insgesamt drei Windungen gezeigt.

Die Leiterbahnbreite W gibt die Breite der Leiterbahn 11 an. Die Leiterbahnbreite W wird über die äußersten Punkte der Leiterbahn 11 bestimmt. In der hier gezeigten Ausführungsform ist die Leiterbahnbreite W über die gesamte Leiterlänge konstant gehalten (d. h. W(t) = const.).

Die Spaltbreite D gibt die Breite des Zwischenraums 12 zwischen den Windungen der Leiterbahn 11 an. Die Spaltbreite D wird über die äußersten Punkte des Bereichs zwischen den benachbarten Windungen der Leiterbahn 11 bestimmt.

Die Ganghöhe der Windungen $P = \int_{tn}^{tn+1} S(t)\mathrm{d}t = S$ für den Fall konstanter Steigung über die Länge einer Windung, S(t) = S von tn bis tn+1 gibt den Abstand in Z'-Richtung zwischen zwei nebeneinanderliegenden Windungen an (also den Vortrieb der Spule nach einer kompletten Windung) und wird über die Zentrallinie der Leiterbahn 11 bestimmt. Eine konstante Ganghöhe P schließt nicht aus, dass die Steigung S innerhalb einer Windung variiert, i.e. auch für den Fall eines nicht konstanten S(t) kann die Ganghöhe P konstant sein, wobei die Ganghöhe P pro Windung abschnittsweise konstant ist.

Die Neigung T der Windungen gibt die Neigung der Windungen gegenüber der Längsachse Z' an und entspricht der Amplitude einer sinusförmigen Modulation der Z'-Position der Leitermittelebene über eine Windung. Bei über mehrere Windungen konstanter Ganghöhe P und Neigung T kann sie einfach bestimmt werden aus Max(Z(t) - Z(t+1)) - S)/2, wobei t im Intervall t0...t0+1 variiert.

Der Radius R der Windungen gibt den Radius an, auf dem die Leiterbahn 11 im Falle kreiszylindrischer Spulen liegt. Im Allgemeinen ist R = R(t), so dass auch nicht-kreiszylindrische Spulen durch ein R beschrieben werden können.

Die in Fig. 4a und Fig. 4b gezeigten Solenoidspulen weisen jeweils eine konstante Leiterbahnbreite W, eine konstante Spaltbreite D und eine konstante Steigung S (und somit auch konstante Ganghöhe P) auf, wobei es sich bei der im Fig. 4a gezeigten Spule um eine geneigte Spule (T ≠ 0) und bei der in Fig. 4a gezeigten Spule um eine nicht geneigte Spule (T = 0).

Die in Fig. 1 und Fig. 2 gezeigten Ausführungsformen der Sende-Empfangsspule 1, 1a weisen jeweils eine konstante Leiterbahnbreite W, eine konstante Ganghöhe P und Neigung T = 0 auf.

Im Folgenden werden spezielle Varianten der Sende-Empfangsspule-Geometrie beschrieben, mit denen die Performance des NMR-Spulenkopfs durch Variation der Spulenparameter weiter verbessert werden kann.

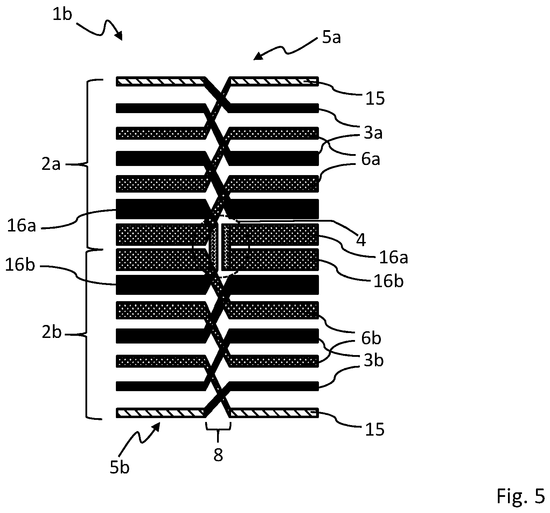

**Fig. 5** zeigt eine alternative Ausführungsform der Sende-Empfangsspule 1b, bei der die Leiterbahnbreite W und die Spaltbreite D entlang der Leiterbahn variabel ist (W = W(t)), wobei die Leiterbahnbreite innerhalb jeder Windung (ausgenommen des Überkreuzungsbereichs 8) konstant (W = const.), sich aber von Windung zu Windung ändert. Im zentralen Anschlussbereich 4 (an dem eine große Potentialdifferenz herrscht) sind die Leiterbahnbreiten W maximal und die Spaltbreiten D minimal. In Richtung der axialen Enden 5a, 5b (wo die Potentialdifferenz kleiner wird) verkleinern sich die Leiterbahnbreiten W und die Spaltbreiten D vergrößern sich entsprechend. An den axialen Enden 5a, 5b (an denen eine minimale Potentialdifferenz vorliegt) sind die Leiterbahnbreiten W minimal und die Spaltbreiten D maximal. Die Leiterbahnbreite W und die Spaltbreite D ist in dieser Ausführungsform also eine Funktion der Potentialdifferenz.

Wie bei der in Fig. 1 gezeigten Ausführungsform weist die in Fig. 5 gezeigte Ausführungsform zwei Spulenabschnitte 2a, 2b mit den Hinwindungen 3a, 3b und Rückwindungen 6a, 6b auf, wobei der elektrische Leiter ausgehend vom zentralen Anschlussbereich 4 zu den jeweiligen axialen Enden 5a, 5b der Sende-Empfangsspule 1 in einer vorgegebenen Ganghöhe P geführt und anschliessend von dort aus mit entgegengesetzter Ganghöhe P wieder zum zentralen Anschlussbereich 4 zurückgeführt wird. Eine variable Leiterbahnbreite W und/oder Spaltbreite D kann jedoch auch bei Ausführungsformen mit nur einem Spulenabschnitt realisiert werden. In diesem Fall vergrößert sich die Spaltbreite D und verringert sich die Leiterbahnbreite W von dem ersten axialen Ende 5a zum zweiten axialen Ende 5b. Mit der in Fig. 5 gezeigten Sende-Empfangsspule 1b ist es einerseits möglich, die elektrischen Felder im Messvolumen zu minimieren und andererseits die Güte der Sende-Empfangsspule 1b zu verbessern, insbesondere dann, wenn das Verhältnis von Leiterbahnbreite und Spaltbreite W/D in den Bereichen geringer Potentialdifferenzen so gewählt wird, dass die elektrischen Verluste in der Sende-Empfangsspule minimiert werden. Im Bereich höherer Potentiale werden zusätzliche elektrische Verluste in der Sende-Empfangsspule in Kauf genommen um die durch die elektrischen Felder in einer Messprobe (in Fig. 5 nicht gezeigt) induzierten Verluste zu reduzieren. Wird die Spaltbreite D im Bereich hoher Potentialdifferenzen zu klein, erhöht sich das Risiko von Spannungsdurchschlägen im Betrieb, so dass es eine durch die Durchschlagsfestigkeit gegebene untere Grenze für die Spaltbreite D gibt. Besonders vorteilhaft ist es, wenn D > 0.01 mm, insbesondere jedoch D > 0.1 mm ist. Dies ermöglicht stark reduzierte elektrische Felder in der Messprobe bei reproduzierbarer Herstellbarkeit und ausreichender Spannungsfestigkeit für typische Messprobendurchmesser im Bereich von 0.5 mm bis 5 mm.

Wie die in Fig. 1 gezeigte Ausführungsform weist auch die in Fig. 5 gezeigte Ausführungsform nicht geneigte Windungen (T(t) = 0) auf. Die Ganghöhe P der Windungen hat einen konstanten Betrag (¦P¦ = const.). Die Ausnahme hiervon bilden die Umkehrwindung 15a, 15b und eine der Anschlusswindungen, die aufgrund der vorgegebenen Randbedingungen (Umkehrung der Ganghöhe P, Position des Anschlussbereichs) den halben Betrag der Ganghöhe P aufweist. Nichtsdestotrotz wird eine solche Spule als Spule mit konstanter Ganghöhe P angesehen. Die Steigung S innerhalb jeder Windung beträgt S(t) = 0 für alle Bereiche ausser der Überkreuzungsbereiche 8. Die oben genannte konstante Ganghöhe der Windungen ¦P¦ = const. wird also durch die Überkreuzungsbereiche 8 realisiert.

Derart gestaltete Solenoidspulen sind unter dem Begriff «zero-pitch» Spule bekannt. In Analogie soll auch eine Spule mit S(t) = 0 für alle t außerhalb der Überkreuzungsbereite als zero-pitch Spule bezeichnet werden.

Im Allgemeinen kann eine variable Leiterbahnbreite W und/oder Spaltbreite D mit beliebigen Steigungen S und/oder Neigungen T eingesetzt werden, solange sich benachbarte Leiterbahnen nicht berühren.

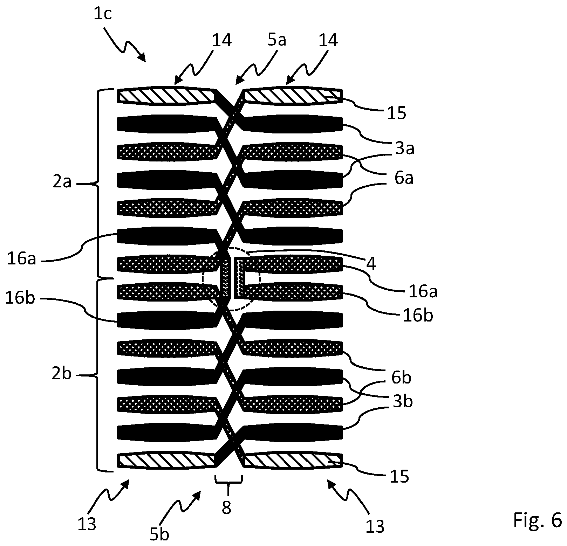

**Fig. 6** zeigt eine weitere alternative Ausführungsform der Sende-Empfangsspule 1c bei der die Leiterbahnbreite W und die Spaltbreite D innerhalb jeder Windung entlang der Ausdehnung der Leiterbahn variiert (W = W(t)). Vorzugsweise sind, wie in Fig. 6 gezeigt, im Überkreuzungsbereich 8 und einem dem Zentrum des Überkreuzungsbereichs 8 (im aufgewickelten Zustand der Sende-Empfangsspule 1c) radial gegenüberliegenden Bereich **13** die Leiterbahnbreiten W minimal und die Spaltbreiten D maximal. In zwei weiteren Bereichen **14** jeder Windung, zwischen dem Überkreuzungsbereich 8 und dem radial gegenüberliegenden Bereich 13, sind die Leiterbahnbreiten W maximal und die Spaltbreiten D minimal. Die minimalen Werte bzw. maximalen Werte sind bei der in Fig. 6 gezeigten Ausführungsform bezüglich einer Rotation um die Längsachse um 180° versetzt angeordnet. Es gibt also zwei Bereiche (Überkreuzungsbereich 8 und radial gegenüberliegender Bereich 13) mit minimalen Leiterbahnbreiten W und zwei Bereiche (weitere Bereiche 14) mit maximalen Leiterbahnbreiten W. Die Variation der Leiterbahnbreiten W erfolgt hier vorzugsweise periodisch.

Wie bei der in Fig. 1 gezeigten Ausführungsform weist die in Fig. 6 gezeigte Ausführungsform zwei Spulenabschnitte 2a, 2b mit den Hinwindungen 3a, 3b und Rückwindungen 6a, 6b auf, wobei der elektrische Leiter ausgehend von einem zentralen Anschlussbereich 4 zu den axialen Enden 5a, 5b der Sende-Empfangsspule 1 mit einer vorgegebenen Ganghöhe P geführt und anschliessend von dort aus mit entgegengesetzter Ganghöhe P wieder zum zentralen Anschlussbereich 4 zurückgeführt wird. Eine Variation der Leiterbahnbreite W und/oder Spaltbreite D kann jedoch auch bei Ausführungsformen mit nur einem Spulenabschnitt realisiert werden.

Mit der in Fig. 6 gezeigten Sende-Empfangsspule 1c ist es möglich, durch die Vergrößerung der Spaltbreite D Zwischenräume («Fenster») zu erhalten, welche eine erhöhte Transparenz für weitere einzustrahlende Magnetfelder bieten. Hierdurch kann ein zweites HF-Magnetfeld, welches beispielsweise durch eine zweite Sende-Empfangsspule (nicht gezeigt) der Sende-Empfangsspulenanordnung des MR-Probenkopfs erzeugt wird, mit dem ersten HF-Magnetfeld der Sende-Empfangsspule 1 überlagert werden. Durch das Vorsehen einer zweiten Sende-Empfangsspule können neben Protonen auch weitere NMR-aktive Kerne untersucht werden.

Wie die in Fig. 5 gezeigte Ausführungsform ist auch die in Fig. 6 gezeigte Ausführungsform eine zero-pitch Spule, wobei die Windungen nicht geneigt sind (T(t) = 0) und eine Ganghöhe P mit konstantem Betrag (¦P¦ = const.) aufweisen.

Eine variable Leiterbahnbreite W und/oder Spaltbreite D kann jedoch mit beliebigen Steigungen S und/oder Neigungen T eingesetzt werden. Weiterhin kann die Variation der Leiterbahnbreite W und/oder Spaltbreite D auch so erfolgen, dass die Leiterbahnbreite nicht im Überkreuzungsbereich 8 minimal ist.

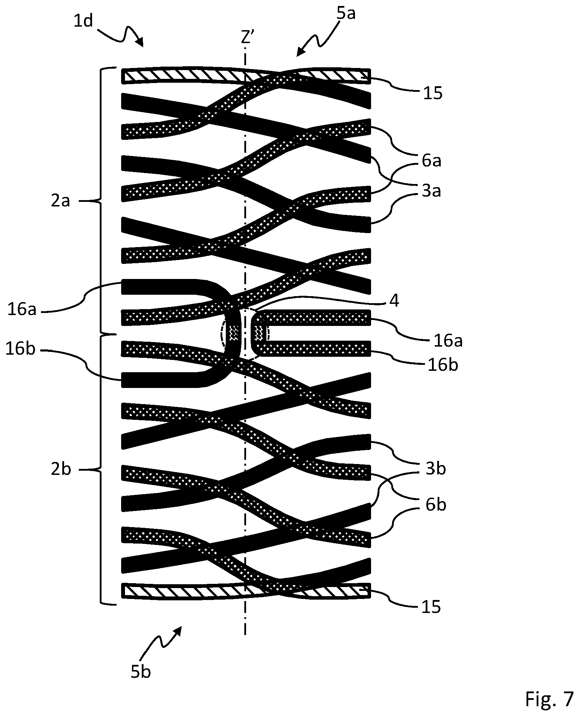

**Fig. 7** zeigt eine weitere alternative Ausführungsform der Sende-Empfangsspule 1d mit im Wesentlichen (d.h. mit Ausnahme der Umkehrwindungen an den Enden der Leitungsabschnitte, also an den axialen Enden 5a, 5b und ggf. an den Anschlusswindungen am zentralen Anschlussbereich 4) konstanter Ganghöhe P, wobei die Steigung S innerhalb jeder Windung variiert. Das bedeutet P(t) ist abschnittsweise konstant mit P(t) = P1, P2, ... für die erste, zweite etc. Windung. Wie bei den zuvor beschriebenen Ausführungsformen weisen die Windungen der in Fig. 7 gezeigte Ausführungsform keine Neigung (T = 0) auf.

Wie bei der in Fig. 1 gezeigten Ausführungsform weist die in Fig. 7 gezeigte Ausführungsform zwei Spulenabschnitte 2a, 2b mit den Hinwindungen 3a, 3b und Rückwindungen 6a, 6b auf, wobei der elektrische Leiter ausgehend von einem zentralen Anschlussbereich 4 zu den axialen Enden 5a, 5b der Sende-Empfangsspule 1 in einem vorgegebenen Windungssinn mit einer vorgegebenen Ganghöhe P geführt und anschliessend von dort aus mit entgegengesetzter Ganghöhe P aber demselben Windungssinn wieder zum zentralen Anschlussbereich 4 zurückgeführt wird. Der Windungssinn der elektrischen Leiter unterscheidet sich zwischen den beiden Spulenabschnitten - d.h. er ist beispielsweise positiv für den Hinwicklungsabschnitt 2a und negativ für den Rückwicklungsabschnitt 2b. Eine konstante Ganghöhe P mit variabler Steigung S innerhalb der Windungen kann jedoch auch bei Ausführungsformen mit nur einem Spulenabschnitt realisiert werden.

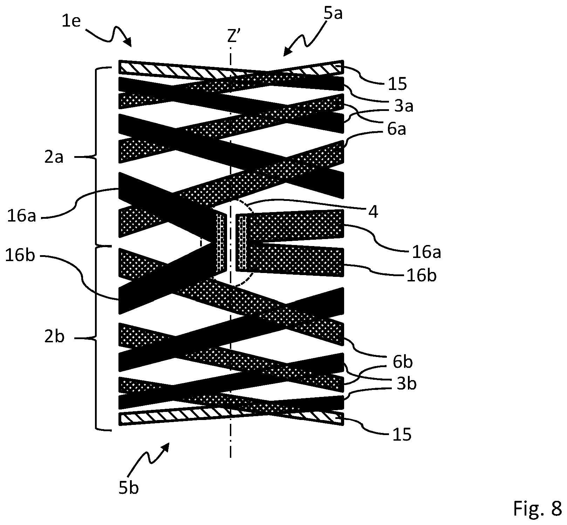

**Fig. 8** zeigt eine weitere alternative Ausführungsform der Sende-Empfangsspule 1e bei der die Ganghöhe P, die Leiterbahnbreite W und die Spaltbreite D der Windungen entlang der gesamten Ausdehnung t des Leiters variabel ist und die Neigung T der Windungen null ist (P = P(t) und T = 0). Bei der in Fig. 8 gezeigten Ausführungsform sind die Ganghöhe P, die Leiterbahnbreite W und die Spaltbreite D beim zentralen Anschlussbereich 4 maximal und nehmen in Richtung der axialen Enden 5a, 5b ab. An den axialen Enden 5a, 5b sind die Ganghöhe P, die Leiterbahnbreite W und die Spaltbreite D minimal (ggf. ausgenommen eine der Anschlusswindungen).

Wie bei der in Fig. 1 gezeigten Ausführungsform weist die in Fig. 8 gezeigte Ausführungsform zwei Spulenabschnitte 2a, 2b mit den Hinwindungen 3a, 3b und Rückwindungen 6a, 6b auf, wobei der elektrische Leiter ausgehend von einem zentralen Anschlussbereich 4 zu den axialen Enden 5a, 5b der Sende-Empfangsspule 1 in einem jeweils vorgegebenen Windungssinn und einer vorgegebenen Ganghöhe P geführt und anschliessend von dort aus mit demselben Windungssinn und entgegengesetzter Ganghöhe P wieder zum zentralen Anschlussbereich 4 zurückgeführt wird. Eine variable Ganghöhe P kann jedoch auch bei Ausführungsformen mit nur einem Spulenabschnitt realisiert werden. Für den Fall des Betriebes nahe an der Eigenresonanz würde sich in diesem Fall die Ganghöhe P von dem ersten axialen Ende zum zweiten axialen Ende verringern. Für den Fall des Betriebes deutlich unterhalb der Eigenresonanz würde sich die Ganghöhe P von dem ersten axialen Ende zur Spulenmitte hin verringern und dann hin zum zweiten axialen Ende wieder erhöhen.

Mit dieser Sende-Empfangsspule 1e ist es möglich, die Homogenität in axialer Richtung zu verbessern, d.h. die endliche Spulenlänge zu kompensieren.

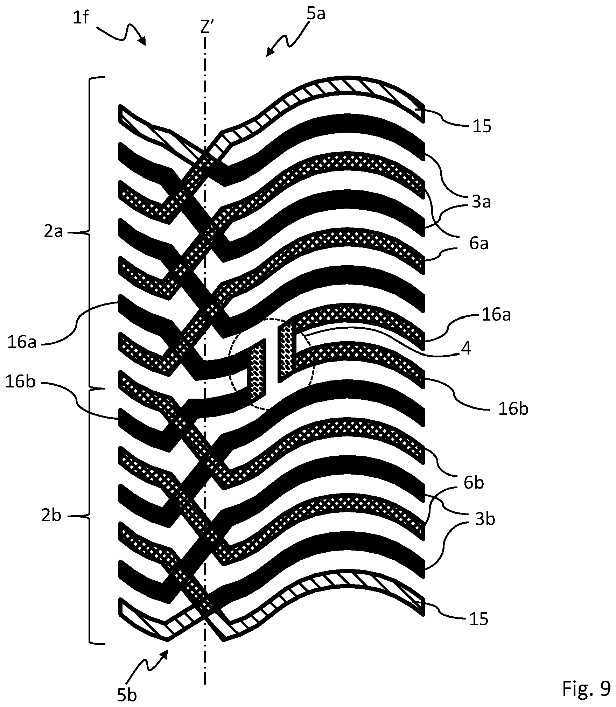

**Fig. 9** zeigt eine weitere alternative Ausführungsform der Sende-Empfangsspule 1f, die gegenüber der Längsachse geneigte Windungen (S ≠ 0) aufweist. Im vorliegenden Fall handelt es sich um eine konstante Neigung T = const. Man kann deutlich erkennen, dass die Z'-Werte innerhalb einer halben Windung größer (hier für die Hinwindungen vom Überkreuzungsbereich ausgehend) und innerhalb der andere halben Windung kleiner werden (hier für die Hinwindungen am Überkreuzungsbereich endend) und somit eine sinusförmige Modulation der Z'-Position darstellen.

Die Ganghöhe P (mit Ausnahme der Umkehrwindungen an den beiden axialen Enden 5a und 5b und einer der Anschlusswindungen) ist über die gesamte Sende-Empfangsspule 1f konstant.

Eine solche Spule ist insbesondere dann von Vorteil, wenn RF-Magnetfelder damit erzeugt werden sollen, die nicht kollinear mit der Zylinderachse (Längsachse Z' der Sende-Empfangsspule) sind. Dies ist insbesondere für eine MAS-NMR-Messprobe von Vorteil, bei der die Zylinderachse Z' und die Richtung des statischen Magnetfeldes unter dem magischen Winkel angeordnet sind. Bei einer solchen Konfiguration kann durch eine konstante Neigung T(t) = const. die Effizienz der Messung der Messprobe erhöht werden.

Wie bei der in Fig. 1 gezeigten Ausführungsform weist die in Fig. 9 gezeigte Ausführungsform zwei Spulenabschnitte 2a, 2b mit den Hinwindungen 3a, 3b und Rückwindungen 6a, 6b auf, wobei der elektrische Leiter ausgehend von einem zentralen Anschlussbereich 4 zu den axialen Enden 5a, 5b der Sende-Empfangsspule 1 in einem vorgegebenen Windungssinn und mit einer Ganghöhe P geführt und anschliessend von dort aus mit gleichem Windungssinn aber entgegengesetzter Ganghöhe P wieder zum zentralen Anschlussbereich 4 zurückgeführt wird. Die Neigung T kann auch von Windung zu Windung oder von Halbwindung zu Halbwindung variabel ausgeführt werden. Eine Neigung T ungleich null oder eine variable Neigung T kann jedoch auch bei Ausführungsformen mit nur einem Spulenabschnitt realisiert werden.

**Fig. 10** zeigt eine schematische Darstellung eines erfindungsgemäßen NMR-Probenkopfs **18**. Ein externes Magnetfeld zur Durchführung von NMR-Messungen wird während des Betriebs im hier gezeigten Beispiel parallel zur Z-Achse ausgerichtet sein. Der NMR-Probenkopf 18 umfasst eine erfindungsgemäße Sende-Empfangsspule 1, die an das Anpassnetzwerk 10 angeschlossen ist und weiterhin einen Spektrometeranschluss **17** für jeden Messkanal. Bei dem in Fig. 10 gezeigten NMR-Probenkopf handelt es sich um einen MAS (magic angle spinning) Probenkopf, bei dem die Längsachse Z' der Sende-Empfangsspule 1 gegenüber der Z-Achse des NMR-Probenkopfs 18 vorzugsweise um den magischen Winkel $\theta$ ($\theta$ = 54,74°) verkippt ist.

Bezugszeichenliste

| | |
|---|---|
| 1, 1a - 1f | Sende-Empfangsspule |
| 2, 2a, 2b | Spulenabschnitt |
| 3, 3a, 3b | Hinwindungen des Spulenabschnitts |
| 4, 4' | Anschlussbereich |
| 5a, 5b | axiale Enden der Sende-Empfangsspule |
| 6, 6a, 6b | Rückwindungen des Spulenabschnitts |
| 7 | Überkreuzungen des el. Leiters |
| 8 | Überkreuzungsbereich |
| 9 | Anschlüsse des Anschlussbereichs 4, 4' |
| 10 | Anpassnetzwerk |
| 11 | Leiterbahn des el. Leiters |
| 12 | Zwischenraum zwischen Windungen der Sende-Empfangsspule |
| 13 | Bereich des Spulenabschnitts mit minimaler Leiterbahnbreiten W und maximaler Spaltbreiten D |
| 14 | Bereiche des Spulenabschnitts mit maximaler Leiterbahnbreiten W und minimaler Spaltbreiten D (weiterer Bereiche) |
| 15, 15a, 15b | Umkehrwindung |
| 16, 16a, 16b | Anschlusswindung |
| 17 | Spektrometeranschluss |
| 18 | NMR-Probenkopf |
| 19 | Messprobe |

List of cited references

| [Pel 2016] | Pel et al. 1H, 23Na and 35Cl Imaging in Cementitious Materials with NMR Appl Magn Reson (2016) 47:265-276 |
| [Krahn 2008] | Krahn et al. Resonator with reduced sample heating and increased homogeneity for solid-state NMR J. Magn. Reson. 191 (2008) 78-92 |
| [Stringer 2005] | Stringer et al. Reduction of RF-induced sample heating with a scroll coil resonator structure for solid-state NMR probes J. Magn. Reson. 173 (2005) 40-48 |
| [Dillmann 2007] | Dillmann et al. A novel low-E field coil to minimize heating of biological samples in solid-state multinuclear NMR experiment J. Magn. Reson. 187 (2007) 10-18 |
| [Gorkov 2007] | Gor' kov et al Using low-E resonators to reduce RF heating in biological samples for static solid-state NMR up to 900 MHz Journal of Magnetic Resonance 185 (2007) 77-93 |
| [Grant 2009] | Grant et al. A Modified Alderman-Grant Coil makes possible an efficient cross-coil probe for high field solid-state NMR of lossy biological samples Journal of Magnetic Resonance 201 (2009) 87-92 |
| [EP1571459] | EP 1 571 459 B1 |
| [JP4787033] | JP 4787033 B2 |
| [US5003265] | US 5,003,265 |
| [US5180982] | US 5,180,982 |
| [US6252403] | US 6,252,403 B1 |
| [US6751847] | US 6,751,847 B1 |
| [US6958608] | US 6,958,608 B2 |
| [US4712068] | US 4,712,068 A |
| [WO2019226624] | WO 2019/226624 A1 |

**Patentansprüche**

1. NMR-Probenkopf mit einer Sende-Empfangsspulenanordnung umfassend mindestens eine Sende-Empfangsspule (1; 1a; 1b; 1c; 1d; 1e; 1f) zur Erzeugung eines HF B1-Magnetfeldes,

   wobei die Sende-Empfangsspule (1; 1a; 1b; 1c; 1d; 1e; 1f) mindestens einen elektrischen Spulenabschnitt (2; 2a, 2b) und einen Anschlussbereich (4; 4') umfasst,
   wobei der elektrische Spulenabschnitt (2; 2a, 2b) einen solenoidförmigen Hinwicklungsabschnitt und einen solenoidförmigen Rückwicklungsabschnitt umfasst,
   wobei der Hinwicklungsabschnitt Hinwindungen (3; 3a, 3b) umfasst und ausgehend von dem Anschlussbereich (4; 4') in einem vorgegebenen Windungssinn zu einem axialen Ende (5a, 5b) der Sende-Empfangsspule (1; 1a; 1b; 1c; 1d; 1e; 1f) führt,
   wobei der Rückwicklungsabschnitt Rückwindungen (6; 6a, 6b) umfasst und ausgehend vom axialen Ende (5a, 5b) der Sende-Empfangsspule (1; 1a; 1b; 1c; 1d; 1e; 1f) im selben Windungssinn zum Anschlussbereich (4; 4') führt, wobei die Windungen des Rückwicklungsabschnitts eine Ganghöhe P mit entgegengesetztem Vorzeichen zu denen des Hinwicklungsabschnitts aufweisen,
   wobei Hin- und Rückwindungen (3, 6; 3a, 3b, 6a, 6b) des elektrischen Spulenabschnitts (2; 2a, 2b) mit Ausnahme von Überkreuzungsbereichen (8), in denen sich die Hin- und Rückwindungen (3, 6; 3a, 3b, 6a, 6b) überkreuzen, auf einer gemeinsamen Zylindermantelfläche um eine Längsachse Z' angeordnet sind,
   **dadurch gekennzeichnet,**
   **dass** die Windungen der Sende-Empfangsspule (1e; 1f) entlang des Spulenabschnitts (2; 2a, 2b) eine variable Neigung gegenüber der Längsachse Z' aufweisen, wobei die Neigung die Amplitude einer sinusförmigen Modulation der Z'-Position der Leitermittelebene über eine Windung beschreibt,
   **dass** der Spulenabschnitt (2; 2a, 2b) eine Umkehrwindung (15) umfasst, die im Betrieb einen Punkt mit Potential 0 aufweist, und
   **dass** die Hinwindungen (3; 3a, 3b) und Rückwindungen (6; 6a, 6b) eines Spulenabschnitts (2; 2a, 2b) mit Ausnahme der Umkehrwindung (15) abwechselnd angeordnet sind.

**2.** NMR -Probenkopf nach Anspruch 1, **dadurch gekennzeichnet, dass** der Anschlussbereich (4') an einem ersten axialen Ende (5a) der Sende-Empfangsspule (1a) angeordnet ist, wobei der Hinwicklungsabschnitt ausgehend von dem Anschlussbereich (4') zu einem zweiten axialen Ende (5b) der Sende-Empfangsspule (1a) führt, und wobei der Rückwicklungsabschnitt ausgehend vom zweiten axialen Ende (5b) der Sende-Empfangsspule (1a) zum Anschlussbereich (4') führt.

**3.** NMR -Probenkopf nach Anspruch 1, **dadurch gekennzeichnet,**

**dass** die Sende-Empfangsspule (1; 1b; 1c; 1d; 1e; 1f) mindestens zwei elektrische Spulenabschnitte (2a, 2b) umfasst, und
**dass** der Anschlussbereich (4) zwischen den beiden Spulenabschnitten (2a, 2b), vorzugsweise mittig, angeordnet ist,
wobei die Hinwindungen (3a, 3b) des ersten elektrischen Spulenabschnitts (2a) ausgehend von dem Anschlussbereich (4) zum ersten axialen Ende (5a) der Sende-Empfangsspule (1; 1b; 1c; 1d; 1e; 1f) und die Rückwindungen (6a) des ersten elektrischen Spulenabschnitts (2a) ausgehend vom ersten axialen (5a) Ende der Sende-Empfangsspule (1; 1b; 1c; 1d; 1e; 1f) zum Anschlussbereich (4) führen, und
wobei die Hinwindungen (3b) des zweiten elektrischen Spulenabschnitts (2b) ausgehend von dem Anschlussbereich (4) zum zweiten axialen Ende (5b) der Sende-Empfangsspule (1; 1b; 1c; 1d; 1e; 1f) und die Rückwindungen (6b) des zweiten elektrischen Spulenabschnitts (2b) ausgehend vom zweiten axialen Ende (5b) der Sende-Empfangsspule (1; 1b; 1c; 1d; 1e; 1f) zum Anschlussbereich (4) führen.

**4.** NMR -Probenkopf nach einem der vorhergehenden Ansprüche, **dadurch gekennzeichnet, dass** die Hin- und Rückwindungen (3, 6; 3a, 3b, 6a, 6b) auf einer Kreiszylindermantelfläche angeordnet sind.

**5.** NMR -Probenkopf nach einem der vorhergehenden Ansprüche, **dadurch gekennzeichnet, dass** die elektrischen Spulenabschnitte (2; 2a, 2b) als bandförmige Spulenabschnitte (2; 2a, 2b) mit einer Leiterbahnbreite W ausgeführt sind.

**6.** NMR -Probenkopf nach Anspruch 5, **dadurch gekennzeichnet, dass** die Leiterbahnbreite W des elektrischen Spulenabschnitts (2a, 2b) und/oder die Spaltbreite D zwischen benachbarten Windungen der Sende-Empfangsspule (1b; 1c) entlang der Länge des elektrischen Spulenabschnitts (2a, 2b) variiert.

**7.** NMR -Probenkopf nach Anspruch 6, **dadurch gekennzeichnet, dass** die Leiterbahnbreite W des elektrischen Spulenabschnitts (2; 2a, 2b) und/oder die Spaltbreite D zwischen benachbarten Windungen der Sende-Empfangsspule (1c) innerhalb jeder Windung variiert.

**8.** NMR -Probenkopf nach einem der vorhergehenden Ansprüche, **dadurch gekennzeichnet, dass** die Steigung S, insbesondere die Ganghöhe P der Windungen entlang der Länge des elektrischen Spulenabschnitts (2a, 2b) variiert.

**9.** NMR -Probenkopf nach Anspruch 8, **dadurch gekennzeichnet, dass** die Ganghöhe P an den axialen Enden (5a, 5b) der Sende-Empfangsspule (1e) kleiner ist als am axialen Zentrum.

**10.** NMR -Probenkopf nach einem der vorherigen Ansprüche, **dadurch gekennzeichnet, dass** mindestens eine Windung außerhalb der Überkreuzungsbereiche (8) eine Steigung S = 0 aufweist, also als nicht geschlossener Ring ausgebildet ist.

## Claims

**1.** NMR probehead having a transceiver coil arrangement comprising at least one transceiver coil (1; 1a; 1b; 1c; 1d; 1e; 1f) for generating an RF B1 magnetic field, wherein the transceiver coil (1; 1a; 1b; 1c; 1d; 1e; 1f) comprises at least one electrical coil portion (2; 2a, 2b) and a connection region (4; 4'),

wherein the electrical coil portion (2; 2a, 2b) comprises a solenoid-shaped forward winding portion and a solenoid-shaped backward winding portion,
wherein the forward winding portion comprises forward windings (3; 3a, 3b) and, starting from the connection region (4; 4'), in a prespecified winding direction, leads to an axial end (5a, 5b) of the transceiver coil (1; 1a; 1b; 1c; 1d; 1e; 1f),

wherein the backward winding portion comprises backward windings (6; 6a, 6b) and, starting from the axial end (5a, 5b) of the transceiver coil (1; 1a; 1b; 1c; 1d; 1e; 1f), in the same winding direction, leads to the connection region (4; 4'), wherein the windings of the backward winding portion have a pitch P of opposite sign to those of the forward winding portion,

wherein the forward and backward windings (3, 6; 3a, 3b, 6a, 6b) of the electrical coil portion (2; 2a, 2b), with the exception of crossover regions (8) in which the forward and backward windings (3, 6; 3a, 3b, 6a, 6b) cross over each other, are arranged on the same cylindrical surface about a longitudinal axis Z',

**characterized in that**

the windings of the transceiver coil (1e; 1f) along the coil portion (2; 2a, 2b) have a variable tilt relative to the longitudinal axis Z', wherein the tilt describes the amplitude of a sinusoidal modulation of the Z' position of the conductor middle plane over a winding,

**in that** the coil portion (2; 2a, 2b) comprises a return winding (15) which has a zero potential point during operation, and

**in that** the forward windings (3; 3a, 3b) and backward windings (6; 6a, 6b) of a coil portion (2; 2a, 2b) are arranged alternating, with the exception of the return winding (15).

2. NMR probehead according to claim 1, **characterized in that** the connection region (4') is arranged at a first axial end (5a) of the transceiver coil (1a), wherein the forward winding portion leads, starting from the connection region (4'), to a second axial end (5b) of the transceiver coil (1a), and wherein the backward winding portion leads, starting from the second axial end (5b) of the transceiver coil, (1a) to the connection region (4').

3. NMR probehead according to claim 1, **characterized**

**in that** the transceiver coil (1; 1b; 1c; 1d; 1e; 1f) comprises at least two electrical coil portions (2a, 2b), and
**in that** the connection region (4) is arranged between the two coil portions (2a, 2b), preferably in the center, wherein the forward windings (3a, 3b) of the first electrical coil portion (2a) lead, starting from the connection region (4), to the first axial end (5a) of the transceiver coil (1; 1b; 1c; 1d; 1e; 1f), and the backward windings (6a) of the first electrical coil portion (2a) lead, starting from the first axial (5a) end of the transceiver coil (1; 1b; 1c; 1d; 1e; 1f), to the connection region (4), and
wherein the forward windings (3b) of the second electrical coil portion (2b) lead, starting from the connection region (4), to the second axial end (5b) of the transceiver coil (1; 1b; 1c; 1d; 1e; 1f), and the backward windings (6b) of the second electrical coil portion (2b) lead, starting from the second axial end (5b) of the transceiver coil (1; 1b; 1c; 1d; 1e; 1f), to the connection region (4).

4. NMR probehead according to any of the preceding claims, **characterized in that** the forward and backward windings (3, 6; 3a, 3b, 6a, 6b) are arranged on a circular cylindrical surface.

5. NMR probehead according to any of the preceding claims, **characterized in that** the electrical coil portions (2; 2a, 2b) are designed as strip-shaped coil portions (2; 2a, 2b) which have a conductor path width W.

6. NMR probehead according to claim 5, **characterized in that** the conductor path width W of the electrical coil portion (2a, 2b) and/or the gap width D between adjacent windings of the transceiver coil (1b; 1c) varies along the length of the electrical coil portion (2a, 2b).

7. NMR probehead according to claim 6, **characterized in that** the conductor path width W of the electrical coil portion (2; 2a, 2b) and/or the gap width D between adjacent windings of the transceiver coil (1c) vary/varies within each winding.

8. NMR probehead according to any of the preceding claims, **characterized in that** the slope S, in particular the pitch P, of the windings varies along the length of the electrical coil portion (2a, 2b).

9. NMR probehead according to claim 8, **characterized in that** the pitch P at the axial ends (5a, 5b) of the transceiver coil (1e) is smaller than at the axial center.

10. NMR probehead according to any one of the preceding claims, **characterized in that** at least one winding has a slope S=0 outside of the crossover regions (8), i.e. is designed as an open ring.

**Revendications**

1. Tête de sonde RMN, avec un agencement de bobines d'émission-réception comprenant au moins une bobine d'émission-réception (1 ; 1a ; 1b ; 1c ; 1d ; 1e ; 1f) permettant de générer un champ magnétique HF B1,

   la bobine d'émission-réception (1 ; 1a ; 1b ; 1c ; 1d ; 1e ; 1f) comprenant au moins une section de bobine électrique (2 ; 2a, 2b) et une région de raccordement (4 ; 4'),
   la section de bobine électrique (2 ; 2a, 2b) comprenant une section d'enroulage vers l'avant en forme de solénoïde et une section d'enroulage vers l'arrière en forme de solénoïde,
   la section d'enroulage vers l'avant comprenant des enroulements vers l'avant (3 ; 3a, 3b) et menant de la région de raccordement (4 ; 4') à une extrémité axiale (5a, 5b) de la bobine d'émission-réception (1 ; 1a ; 1b ; 1c ; 1d ; 1e ; 1f) dans un sens d'enroulement prédéterminé,
   la section d'enroulage vers l'arrière comprenant des enroulements vers l'arrière (6 ; 6a, 6b) et menant de l'extrémité axiale (5a, 5b) de la bobine d'émission-réception (1 ; 1a ; 1b ; 1c ; 1d ; 1e ; 1f) à la région de raccordement (4 ; 4') dans le même sens de rotation, les enroulements de la section d'enroulage vers l'arrière présentant un pas P de signe opposé à celui de la section d'enroulage vers l'avant,
   des enroulements vers l'avant et vers l'arrière (3, 6 ; 3a, 3b, 6a, 6b) de la section de bobine électrique (2 ; 2a, 2b) étant agencés sur une surface d'enveloppe de cylindre commune autour d'un axe longitudinal Z', à l'exception de régions de croisement (8) dans lesquelles les enroulements vers l'avant et vers l'arrière (3, 6 ; 3a, 3b, 6a, 6b) se croisent,
   **caractérisée en ce que**
   les enroulements de la bobine d'émission-réception (1e ; 1f) le long de la section de bobine (2 ; 2a, 2b) présentent une inclinaison variable par rapport à l'axe longitudinal Z', l'inclinaison décrivant l'amplitude d'une modulation sinusoïdale de la position Z' du plan médian de conducteur sur un enroulement,
   la section de bobine (2 ; 2a, 2b) comprend un enroulement d'inversion (15) qui présente un point à potentiel 0 en fonctionnement, et
   les enroulements vers l'avant (3 ; 3a, 3b) et vers l'arrière (6 ; 6a, 6b) d'une section de bobine (2 ; 2a, 2b) étant agencés de manière alternée, à l'exception de l'enroulement inverse (15).

2. Tête de sonde RMN selon la revendication 1, **caractérisée en ce que** la région de raccordement (4') est agencée au niveau d'une première extrémité axiale (5a) de la bobine d'émission-réception (1a), la section d'enroulage vers l'avant menant de la région de raccordement (4') à une seconde extrémité axiale (5b) de la bobine d'émission-réception (1a), et la section d'enroulage vers l'arrière menant de la seconde extrémité axiale (5b) de la bobine d'émission-réception (1a) à la région de raccordement (4').

3. Tête de sonde RMN selon la revendication 1, **caractérisée en ce que** la bobine d'émission-réception (1 ; 1b ; 1c ; 1c1 ; 1e ; 1f) comprend au moins deux sections de bobine électriques (2a, 2b), et

   la région de raccordement (4) est agencée entre les deux sections de bobine (2a, 2b), de manière préférée au centre,
   les enroulements vers l'avant (3a, 3b) de la première section de bobine électrique (2a) menant de la région de raccordement (4) à la première extrémité axiale (5a) de la bobine d'émission-réception (1 ; 1b ; 1c ; 1d ; 1e ; 1f) et les enroulements vers l'arrière (6a) de la première section de bobine électrique (2a) menant de la première extrémité axiale (5a) de la bobine d'émission-réception (1 ; 1b ; 1c ; 1d ; 1e ; 1f) à la région de raccordement (4), et les enroulements vers l'avant (3b) de la seconde section de bobine électrique (2b) menant de la région de raccordement (4) à la seconde extrémité axiale (5b) de la bobine d'émission-réception (1 ; 1b ; 1c ; 1d ; 1e ; 1f) et les enroulements vers l'arrière (6b) de la seconde section de bobine électrique (2b) menant de la seconde extrémité axiale (5b) de la bobine d'émission-réception (1 ; 1b ; 1c ; 1d ; 1e ; 1f) à la région de raccordement (4).

4. Tête de sonde RMN selon l'une quelconque des revendications précédentes, **caractérisée en ce que** les enroulements vers l'avant et vers l'arrière (3, 6 ; 3a, 3b, 6a, 6b) sont agencés sur une surface d'enveloppe de cylindre circulaire.

5. Tête de sonde RMN selon l'une quelconque des revendications précédentes, **caractérisée en ce que** les sections de bobine électriques (2 ; 2a, 2b) sont réalisées sous la forme de sections de bobine en forme de bande (2 ; 2a, 2b) avec une largeur de piste conductrice W.

6. Tête de sonde RMN selon la revendication 5, **caractérisée en ce que** la largeur de piste conductrice W de la section de bobine électrique (2a, 2b) et/ou la largeur d'intervalle D entre des enroulements adjacents de la bobine d'émission-réception (1b ; 1c) varie le long de la longueur de la section de bobine électrique (2a, 2b).

7. Tête de sonde RMN selon la revendication 6, **caractérisée en ce que** la largeur de piste conductrice W de la section de bobine électrique (2 ; 2a, 2b) et/ou la largeur d'intervalle D entre des enroulements adjacents de la bobine d'émission-réception (1c) varie à l'intérieur de chaque enroulement.

8. Tête de sonde RMN selon l'une quelconque des revendications précédentes, **caractérisée en ce que** la pente S, en particulier le pas P des enroulements, varie le long de la longueur de la section de bobine électrique (2a, 2b).

9. Tête de sonde RMN selon la revendication 8, **caractérisée en ce que** le pas P au niveau des extrémités axiales (5a, 5b) de la bobine d'émission-réception (1e) est plus petit qu'au niveau du centre axial.

10. Tête d'échantillon RMN selon l'une quelconque des revendications précédentes, **caractérisée en ce qu'**au moins un enroulement situé à l'extérieur des régions de croisement (8) présente un pas S = 0, c'est-à-dire qu'il est réalisé sous la forme d'un anneau non fermé.

Fig. 1a

Fig. 1b

Fig. 2a

Fig. 2b

Fig. 3

Fig. 4a

Fig. 4b

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5003265 A
- US 5180982 A
- JP 4787033 B
- EP 1571459 A
- US 6751847 B
- US 4712068 A
- WO 2019226624 A
- EP 1571459 B1
- US 6252403 B
- US 6252403 B1
- US 6751847 B1
- US 6958608 B
- US 6958608 B2
- WO 2019226624 A1

**In der Beschreibung aufgeführte Nicht-Patentliteratur**

- **PEL et al.** 1H, 23Na and 35Cl Imaging in Cementitious Materials with NMR. *Appl Magn Reson*, 2016, vol. 47, 265-276
- **KRAHN et al.** Resonator with reduced sample heating and increased homogeneity for solid-state NMR. *J. Magn. Reson.*, 2008, vol. 191, 78-92
- **STRINGER et al.** Reduction of RF-induced sample heating with a scroll coil resonator structure for solid-state NMR probes. *J. Magn. Reson.*, 2005, vol. 173, 40-48
- **DILLMANN et al.** A novel low-E field coil to minimize heating of biological samples in solid-state multinuclear NMR experiment. *J. Magn. Reson.*, 2007, vol. 187, 10-18
- **GOR' KOV et al.** Using low-E resonators to reduce RF heating in biological samples for static solid-state NMR up to 900 MHz. *Journal of Magnetic Resonance*, 2007, vol. 185, 77-93
- **GRANT et al.** A Modified Alderman-Grant Coil makes possible an efficient cross-coil probe for high field solid-state NMR of lossy biological samples. *Journal of Magnetic Resonance*, 2009, vol. 201, 87-92